# EUROPEAN PATENT APPLICATION

(11) **EP 4 266 347 A1**
(43) Date of publication of application: **25.10.2023**
(21) Application number: 22168912.8
(22) Date of filing: 19.04.2022
(51) Int. Cl.: H01J 37/244

(54) **METHOD OF FILTERING FALSE POSITIVES FOR A PIXELATED ELECTRON DETECTOR**

(71) Applicant: ASML Netherlands B.V., 5500 AH Veldhoven (NL)
(72) Inventor: VAN WEPEREN, Ilse, 5500 AH Veldhoven (NL); REN, Yan, 5500 AH Veldhoven (NL)
(74) Representative: ASML Netherlands B.V.

(57) **Abstract**

A method for filtering false positives in a charged particle beam detector includes utilizing spatial information of detected charged particle landing events on the detector. A spatial distribution of detected charged particle landing events on the detector is compared to an expected distribution of landing events to determine the probability that the charged particle landing events are real.

## Description

### FIELD

The description herein relates to charged particle counting detectors that may be useful in the field of charged particle beam systems, and more particularly, to systems and methods for filtering false detection data in the charged particle counting detectors.

### BACKGROUND

Detectors may be used for sensing physically observable phenomena. For example, charged particle beam tools, such as electron microscopes, may comprise detectors that receive charged particles projected from a sample and that output detection signals. Detection signals may be used to reconstruct images of sample structures under inspection and may be used, for example, in metrology processes or to reveal defects in the sample. Metrology relates to precision measurements of sample structures and other miniaturized features. For example, in a semiconductor wafer, metrology may include such measurements as critical dimension (width of the smallest device feature), critical dimension uniformity, linewidth, overlay, line edge roughness, line end shortening, floor tilt, sidewall angle, and other dimensional parameters. Metrology may also include material analysis based on reconstructed images from the detection signals. Detection of defects in a sample is also increasingly important in the manufacturing of semiconductor devices, which may include large numbers of densely packed, miniaturized integrated circuit (IC) components. Inspection systems may be provided for these and other purposes.

With continuing miniaturization of semiconductor devices, inspection systems may use lower and lower beam currents in charged particle beam tools. Existing detection systems may be limited by signal-to-noise ratio (SNR) and system throughput, particularly when beam current reduces to, for example, pico-ampere ranges. Electron counting has been proposed to enhance SNR and to increase throughput in electron beam inspection systems, wherein the intensity of an incoming electron beam is acquired by counting the number of electrons that reach the detector, and then analyzing the frequency of electron arrival events. However, because some phenomena may be incorrectly detected as an electron arrival event, electron counting detectors may be negatively impacted by false detection data.

### SUMMARY

Embodiments of the present disclosure provide systems and methods for filtering false detection data in a charged particle beam process.

Some embodiments provide a non-transitory computer-readable medium storing a set of instructions that are executable by at least one processor of a device to cause the device to perform a method comprising: obtaining spatial distribution information of detected charged particle incidence locations on a charged particle detector; comparing the spatial distribution information to reference distribution information; and assigning a value to a detected charged particle incidence location based on the comparison.

In some embodiments of the present disclosure, the reference distribution information comprises expected incidence locations on the charged particle detector. The expected incidence locations may be based on a charged particle beam parameter of a charged particle beam apparatus, or on a sample pixel parameter of a sample at a sample pixel location in a charged particle beam process.

In some embodiments of the present disclosure, the spatial distribution information comprises a first spatial counts map of a first sample pixel in a charged particle beam process; and the reference distribution information comprises a second spatial counts map of a second sample pixel in the charged particle beam process.

In some embodiments of the present disclosure, the spatial distribution information comprises a first frame of a spatial counts map of a sample pixel in a charged particle beam process; and the reference distribution information comprises a second frame of the spatial counts map of the sample pixel in the charged particle beam process.

It is to be understood that both the foregoing general description and the following detailed description are exemplary and explanatory only and are not restrictive of the disclosed embodiments, as may be claimed.

### BRIEF DESCRIPTION OF THE DRAWINGS

The above and other aspects of the present disclosure will become more apparent from the description of exemplary embodiments, taken in conjunction with the accompanying drawings.
**Fig. 1** is a diagrammatic representation of an exemplary electron beam inspection (EBI) system, consistent with embodiments of the present disclosure.
**Figs. 2A-C** are diagrams illustrating charged particle beam apparatus that may be examples of an electron beam tool, consistent with embodiments of the present disclosure.
**Fig. 2D** illustrates an electron arrival distribution on an exemplary detector in a charged particle beam apparatus, consistent with embodiments of the present disclosure.
**Figs. 3A-B** are diagrammatic representations of exemplary structures of a detector in a charged particle beam apparatus, consistent with embodiments of the present disclosure.
**Figs. 4A-D** illustrate historical information examples of expected electron arrival locations, consistent with some embodiments of the present disclosure.
**Figs. 5A-C** illustrate example weighting distributions for spatial counts maps, consistent with some embodiments of the present disclosure.
**Fig. 6** illustrates an example comparison of two spatial counts maps, consistent with some embodiments of the present disclosure.
**Fig. 7** illustrates an example comparison of two spatial counts maps, consistent with some embodiments of the present disclosure.
**Fig. 8** illustrates an example weighting distribution for a spatial counts map in a charged particle beam process, consistent with some embodiments of the present disclosure.
**Fig. 9** illustrates a flowchart of an example method of filtering false positives in a charged particle beam detection process, consistent with some embodiments of the present disclosure.
**Fig. 10** illustrates a flowchart of an example method of filtering false positives in a charged particle beam detection process, consistent with some embodiments of the present disclosure.
**Fig. 11** illustrates a flowchart of an example method of filtering false positives in a charged particle beam detection process, consistent with some embodiments of the present disclosure.

### DETAILED DESCRIPTION

Reference will now be made in detail to exemplary embodiments, examples of which are illustrated in the drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses, systems, and methods consistent with aspects related to subject matter that may be recited in the appended claims.

Electronic devices are constructed of circuits formed on a piece of silicon called a substrate. Many circuits may be formed together on the same piece of silicon and are called integrated circuits or ICs. With advancements in technology, the size of these circuits has decreased dramatically so that many more of them can fit on the substrate. For example, an IC chip in a smart phone can be as small as a fingernail and yet may include over 2 billion transistors, the size of each transistor being less than 1/1,000th the width of a human hair.

Making these extremely small ICs is a complex, time-consuming, and expensive process, often involving hundreds of individual steps. Errors in even one step have the potential to result in defects in the finished IC, rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). A SEM can be used to image these extremely small structures, in effect, taking a "picture" of the structures. The image can be used to determine if the structure was formed properly and also if it was formed in the proper location. If the structure is defective, then the process can be adjusted so the defect is less likely to recur. To enhance throughput (e.g., the number of samples processed per hour), it is desirable to conduct inspection as quickly as possible.

An image of a wafer may be formed by scanning one or more primary beams of a SEM system (e.g., a "probe" beam) over the wafer and collecting particles (e.g., secondary electrons) generated from the wafer surface at a detector. Secondary electrons may form one or more secondary beams that are directed toward the detector. For each secondary beam, secondary electrons landing on the detector may cause electrical signals (e.g., current, charge, voltage, etc.) to be generated in the detector. These signals may be output from the detector and may be processed by an image processor to form the image of the sample.

Typically, the detection process involves measuring the magnitude of an electrical signal generated when electrons land on the detector. In another approach, electron counting may be used, in which a detector may count individual electron arrival events as they occur. In either approach, intensity of the secondary beam may be determined based on electrical signals generated in the detector that vary in proportion to the change in intensity of the secondary beam. Using electron counting, however, the discrete numbers of electrons that reach the detector from a beam of secondary electrons may be determined, and detection results may be output in digital form. The intensity of the beam may be determined by analyzing the frequency of electron arrival events.

Electron counting may be helpful to improve signal-to-noise ratio (SNR) and throughput of a charged particle beam system. SNR may be a concern especially at low levels of primary beam current. Thus, electron counting may be an attractive method in applications such as metrology and overlay inspections where beam current is usually low. Electron counting may also be useful in separating signals generated by different types of electrons (e.g., secondary electrons and backscattered electrons). In some applications, it may be desired to generate SEM images based purely on secondary electrons, based purely on backscattered electrons, or a combination thereof.

However, while electron counting may improve SNR as discussed above, individual information is lost after all detector pixels are read-out and the counts are summed. Therefore, detection output may still be impacted by false detections within the summed data. A detection system may be impacted by a false positive (incorrectly determining an electron arrival) or a false negative (failure to detect an electron arrival) in the detector.

A false positive may be an event that incorrectly signals an electron arrival. For example, background noise in a detector may be caused by, among other things, dark current in a diode. For example, imperfections in a crystal structure of a semiconductor device acting as a diode may cause current fluctuation. Dark current in a detector may be due to defects in materials forming the detector and may arise even when there is no incident irradiation. "Dark" current may refer to the fact that a current fluctuation is not related to any incoming charged particle, but may nevertheless be interpreted as an arrival event. Various sources of noise, such as dark current, thermal energy, extraneous radiation, etc., may cause unintended current fluctuations in a detector's output.

A false negative may be a failure to detect an electron arrival event. False negatives may be caused by, e.g., malfunctioning or "dead" detector cells, event signal overlap (e.g., detecting two electron arrival events as one), or signal thresholding.

Due to the increasing complexity and decreasing feature size of modern integrated circuit patterns, modern inspection processes require extremely low rates of false detection data. Therefore, further improvements to a SNR are desired. Embodiments of the present disclosure may provide systems and methods for filtering false positives in an electron detector. The system uses spatial information collected in a pixelated electron counting detector (PECD) to ascertain the probability that a detected event is genuine and assign an appropriate weighting coefficient to the detected event in the count summation.

Objects and advantages of the disclosure may be realized by the elements and combinations as set forth in the embodiments discussed herein. However, embodiments of the present disclosure are not necessarily required to achieve such exemplary objects or advantages, and some embodiments may not achieve any of the stated objects or advantages.

Without limiting the scope of the present disclosure, some embodiments may be described in the context of providing detection systems and detection methods in systems utilizing electron beams ("e-beams"). However, the disclosure is not so limited. Other types of charged particle beams may be similarly applied. Furthermore, systems and methods for detection may be used in other imaging systems, such as optical imaging, photon detection, x-ray detection, ion detection, etc.

As used herein, unless specifically stated otherwise, the term "or" encompasses all possible combinations, except where infeasible. For example, if it is stated that a component includes A or B, then, unless specifically stated otherwise or infeasible, the component may include A, or B, or A and B. As a second example, if it is stated that a component includes A, B, or C, then, unless specifically stated otherwise or infeasible, the component may include A, or B, or C, or A and B, or A and C, or B and C, or A and B and C.

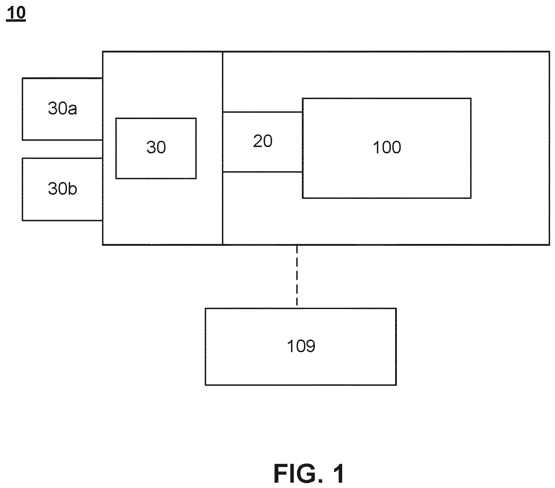

Reference is now made to **Fig. 1****,** which illustrates an exemplary electron beam inspection (EBI) system 10 that may be used for wafer inspection, consistent with embodiments of the present disclosure. As shown in **Fig. 1****,** EBI system 10 includes a main chamber 11 a load/lock chamber 20, an electron beam tool 100 (e.g., a scanning electron microscope (SEM)), and an equipment front end module (EFEM) 30. Electron beam tool 100 is located within main chamber 11 and may be used for imaging. EFEM 30 includes a first loading port 30a and a second loading port 30b. EFEM 30 may include additional loading ports. First loading port 30a and second loading port 30b receive wafer front opening unified pods (FOUPs) that contain wafers (e.g., semiconductor wafers or wafers made of other materials) or samples to be inspected (wafers and samples may be collectively referred to as "wafers" herein).

One or more robotic arms (not shown) in EFEM 30 may transport the wafers to load/lock chamber 20. Load/lock chamber 20 is connected to a load/lock vacuum pump system (not shown) which removes gas molecules in load/lock chamber 20 to reach a first pressure below the atmospheric pressure. After reaching the first pressure, one or more robotic arms (not shown) may transport the wafer from load/lock chamber 20 to main chamber 11. Main chamber 11 is connected to a main chamber vacuum pump system (not shown) which removes gas molecules in main chamber 11 to reach a second pressure below the first pressure. After reaching the second pressure, the wafer is subject to inspection by electron beam tool 100. Electron beam tool 100 may be a single-beam system or a multi-beam system. A controller 109 is electronically connected to electron beam tool 100, and may be electronically connected to other components as well. Controller 109 may be a computer configured to execute various controls of EBI system 10. While controller 109 is shown in **Fig. 1** as being outside of the structure that includes main chamber 11, load/lock chamber 20, and EFEM 30, it is appreciated that controller 109 can be part of the structure.

A charged particle beam microscope, such as that formed by or which may be included in EBI system 10, may be capable of resolution down to, e.g., the nanometer scale, and may serve as a practical tool for inspecting IC components on wafers. With an e-beam system, electrons of a primary electron beam may be focused at probe spots on a wafer under inspection. The interactions of the primary electrons with the wafer may result in secondary particle beams being formed. The secondary particle beams may comprise backscattered electrons, secondary electrons, or Auger electrons, etc. resulting from the interactions of the primary electrons with the wafer. Characteristics of the secondary particle beams (e.g., intensity) may vary based on the properties of the internal or external structures or materials of the wafer, and thus may indicate whether the wafer includes defects.

The intensity of the secondary particle beams may be determined using a detector. The secondary particle beams may form beam spots on a surface of the detector. The detector may generate electrical signals (e.g., a current, a charge, a voltage, etc.) that represent intensity of the detected secondary particle beams. The electrical signals may be measured with measurement circuitries which may include further components (e.g., analog-to-digital converters) to obtain a distribution of the detected electrons. The electron distribution data collected during a detection time window, in combination with corresponding scan path data of the primary electron beam incident on the wafer surface, may be used to reconstruct images of the wafer structures or materials under inspection. The reconstructed images may be used to reveal various features of the internal or external structures or materials of the wafer and may be used to reveal defects that may exist in the wafer.

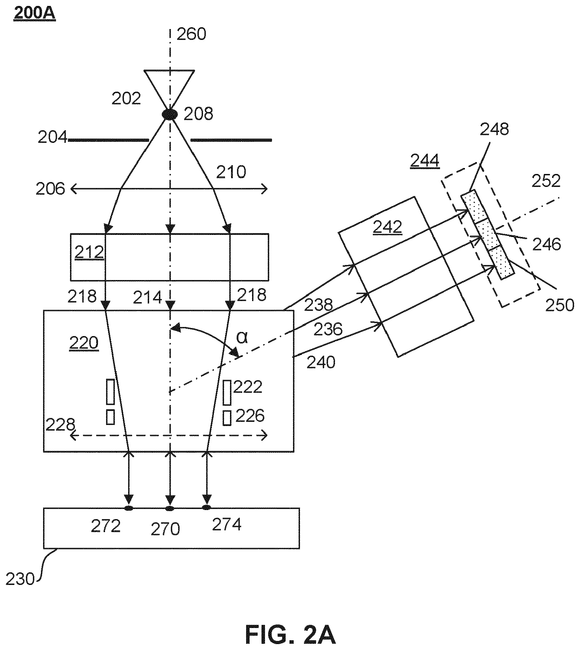

**Fig. 2A** illustrates an example of a charged particle beam apparatus that may be an example of electron beam tool 100, consistent with embodiments of the present disclosure. Charged particle beam apparatus 200A may be a multi-beam tool that uses a plurality of beamlets formed from a primary electron beam to simultaneously scan multiple locations on a wafer.

As shown in **Fig. 2A****,** electron beam tool 200A may comprise an electron source 202, a gun aperture 204, a condenser lens 206, a primary electron beam 210 emitted from electron source 202, a source conversion unit 212, a plurality of beamlets 214, 216, and 218 of primary electron beam 210, a primary projection optical system 220, a wafer stage (not shown in **Fig. 2A****),** multiple secondary electron beams 236, 238, and 240, a secondary optical system 242, and electron detection device 244. Electron source 202 may generate primary particles, such as electrons of primary electron beam 210. A controller, image processing system, and the like may be coupled to electron detection device 244. Primary projection optical system 220 may comprise beam separator 222, deflection scanning unit 226, and objective lens 228. Electron detection device 244 may comprise detection sub-regions 246, 248, and 250.

Electron source 202, gun aperture 204, condenser lens 206, source conversion unit 212, beam separator 222, deflection scanning unit 226, and objective lens 228 may be aligned with a primary optical axis 260 of apparatus 200A. Secondary optical system 242 and electron detection device 244 may be aligned with a secondary optical axis 252 of apparatus 200A.

Electron source 202 may comprise a cathode, an extractor or an anode, wherein primary electrons can be emitted from the cathode and extracted or accelerated to form a primary electron beam 210 with a crossover (virtual or real) 208. Primary electron beam 210 can be visualized as being emitted from crossover 208. Gun aperture 204 may block off peripheral electrons of primary electron beam 210 to reduce size of probe spots 270, 272, and 274.

Source conversion unit 212 may comprise an array of image-forming elements (not shown in **Fig. 2A****)** and an array of beam-limit apertures (not shown in **Fig. 2A****).** An example of source conversion unit 212 may be found in U.S. Patent No 9,691,586; U.S. Publication No. 2017/0025243; and International Publication No. WO/2018122176, all of which are incorporated by reference in their entireties. The array of image-forming elements may comprise an array of micro-deflectors or microlenses. The array of image-forming elements may form a plurality of parallel images (virtual or real) of crossover 208 with a plurality of beamlets 214, 216, and 218 of primary electron beam 210. The array of beam-limit apertures may limit the plurality of beamlets 214, 216, and 218.

Condenser lens 206 may focus primary electron beam 210. The electric currents of beamlets 214, 216, and 218 downstream of source conversion unit 212 may be varied by adjusting the focusing power of condenser lens 206 or by changing the radial sizes of the corresponding beam-limit apertures within the array of beam-limit apertures. Condenser lens 206 may be an adjustable condenser lens that may be configured so that the position of its first principal plane is movable. The adjustable condenser lens may be configured to be magnetic, which may result in off-axis beamlets 216 and 218 landing on the beamlet-limit apertures with rotation angles. The rotation angles change with the focusing power and the position of the first principal plane of the adjustable condenser lens. In some embodiments, the adjustable condenser lens may be an adjustable anti-rotation condenser lens, which involves an anti-rotation lens with a movable first principal plane. An example of an adjustable condenser lens is further described in U.S. Publication No. 2017/0025241, which is incorporated by reference in its entirety.

Objective lens 228 may focus beamlets 214, 216, and 218 onto a wafer 230 for inspection and may form a plurality of probe spots 270, 272, and 274 on the surface of wafer 230. Secondary electron beamlets 236, 238, and 240 may be formed that are emitted from wafer 230 and travel back toward beam separator 222.

Beam separator 222 may be a beam separator of Wien filter type generating an electrostatic dipole field and a magnetic dipole field. In some embodiments, if they are applied, the force exerted by electrostatic dipole field on an electron of beamlets 214, 216, and 218 may be equal in magnitude and opposite in direction to the force exerted on the electron by magnetic dipole field. Beamlets 214, 216, and 218 can therefore pass straight through beam separator 222 with zero deflection angle. However, the total dispersion of beamlets 214, 216, and 218 generated by beam separator 222 may also be nonzero. Beam separator 222 may separate secondary electron beams 236, 238, and 240 from beamlets 214, 216, and 218 and direct secondary electron beams 236, 238, and 240 towards secondary optical system 242.

Deflection scanning unit 226 may deflect beamlets 214, 216, and 218 to scan probe spots 270, 272, and 274 over an area on a surface of wafer 230. In response to incidence of beamlets 214, 216, and 218 at probe spots 270, 272, and 274, secondary electron beams 236, 238, and 240 may be emitted from wafer 230. Secondary electron beams 236, 238, and 240 may comprise electrons with a distribution of energies including secondary electrons and backscattered electrons. Secondary optical system 242 may focus secondary electron beams 236, 238, and 240 onto detection sub-regions 246, 248, and 250 of electron detection device 244. Detection sub-regions 246, 248, and 250 may be configured to detect corresponding secondary electron beams 236, 238, and 240 and generate corresponding signals used to reconstruct an image of the surface of wafer 230. Detection sub-regions 246, 248, and 250 may include separate detector packages, separate sensing elements, or separate regions of an array detector. In some embodiments, each detection sub-region may include a single sensing element.

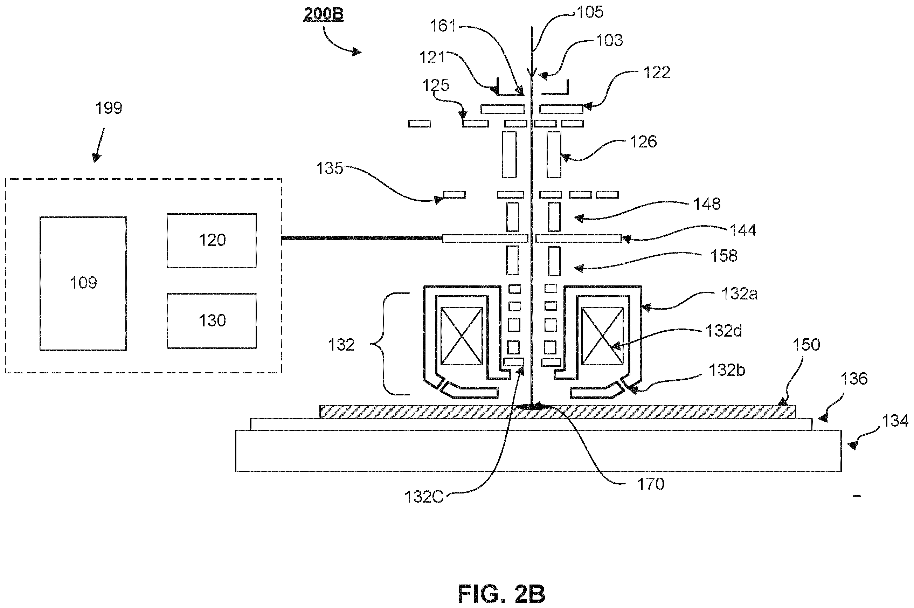

**Fig. 2B** illustrates another example of a charged particle beam apparatus, consistent with embodiments of the present disclosure. Electron beam tool 200B (also referred to herein as apparatus 200B) may be an example of electron beam tool 100. Electron beam tool 200B may be similar to electron beam tool 200A shown in **Fig. 2A****.** However, different from apparatus 200A, apparatus 200B may be a single-beam tool that uses one primary electron beam to scan one location on the wafer at a time.

As shown in **Fig. 2B****,** apparatus 200B includes a wafer holder 136 supported by motorized stage 134 to hold a wafer 150 to be inspected. Electron beam tool 200B includes an electron emitter, which may comprise a cathode 103, an anode 121, and a gun aperture 122. Electron beam tool 200B further includes a beam limit aperture 125, a condenser lens 126, a column aperture 135, an objective lens assembly 132, and a detector 144. Objective lens assembly 132, in some embodiments, may be a modified SORIL lens, which includes a pole piece 132a, a control electrode 132b, a deflector 132c, and an exciting coil 132d. In a detection or imaging process, an electron beam 161 emanating from the tip of cathode 103 may be accelerated by anode 121 voltage, pass through gun aperture 122, beam limit aperture 125, condenser lens 126, and be focused into a probe spot 170 by the modified SORIL lens and impinge onto the surface of wafer 150. Probe spot 170 may be scanned across the surface of wafer 150 by a deflector, such as deflector 132c or other deflectors in the SORIL lens. Secondary or scattered particles, such as secondary electrons or scattered primary electrons emanated from the wafer surface may be collected by detector 144 to determine intensity of the beam and so that an image of an area of interest on wafer 150 may be reconstructed.

It is appreciated that electron beam tools 200A and 200B may include an image processing system 199 that includes an image acquirer 120, a storage 130, and controller 109. Image acquirer 120 may comprise one or more processors. For example, image acquirer 120 may comprise a computer, server, mainframe host, terminals, personal computer, any kind of mobile computing devices, and the like, or a combination thereof. Image acquirer 120 may connect with detector 144 of electron beam tool 200B through a medium such as an electrical conductor, optical fiber cable, portable storage media, IR, Bluetooth, internet, wireless network, wireless radio, or a combination thereof. Image acquirer 120 may receive a signal from detector 144 and may construct an image. Image acquirer 120 may thus acquire images of wafer 150. Image acquirer 120 may also perform various post-processing functions, such as image averaging, generating contours, superimposing indicators on an acquired image, and the like. Image acquirer 120 may be configured to perform adjustments of brightness and contrast, etc. of acquired images. Storage 130 may be a storage medium such as a hard disk, random access memory (RAM), cloud storage, other types of computer readable memory, and the like. Storage 130 may be coupled with image acquirer 120 and may be used for saving scanned raw image data as original images, and post-processed images. Image acquirer 120 and storage 130 may be connected to controller 109. In some embodiments, image acquirer 120, storage 130, and controller 109 may be integrated together as one electronic control unit.

In some embodiments, image acquirer 120 may acquire one or more images of a sample based on an imaging signal received from detector 144. An imaging signal may correspond to a scanning operation for conducting charged particle imaging. An acquired image may be a single image comprising a plurality of imaging areas that may contain various features of wafer 150. The single image may be stored in storage 130. Imaging may be performed on the basis of imaging frames.

The condenser and illumination optics of the electron beam tool may comprise or be supplemented by electromagnetic quadrupole electron lenses. For example, as shown in **Fig. 2B****,** electron beam tool 200B may comprise a first quadrupole lens 148 and a second quadrupole lens 158. In some embodiments, the quadrupole lenses may be used for controlling the electron beam. For example, first quadrupole lens 148 may be controlled to adjust the beam current and second quadrupole lens 158 may be controlled to adjust the beam spot size and beam shape.

In some embodiments of the disclosure, a PIN detector may be used as an in-lens detector in a retarding objective lens SEM column of EBI system 10. The PIN detector may be placed between a cathode for generating an electron beam and the objective lens. The electron beam emitted from the cathode may be potentialized at -BE keV (typically around -10 kV). Electrons of the electron beam may be immediately accelerated and travel through the column. The column may be at ground potential. Thus, electrons may travel with kinetic energy of BE keV while passing through opening 145 of detector 144. Electrons passing through the pole piece of the objective lens, such as pole piece 132a of objective lens assembly 132 of **Fig. 2B****,** may be steeply decelerated down to landing energy LE keV as the wafer surface potential may be set at -(BE - LE) keV.

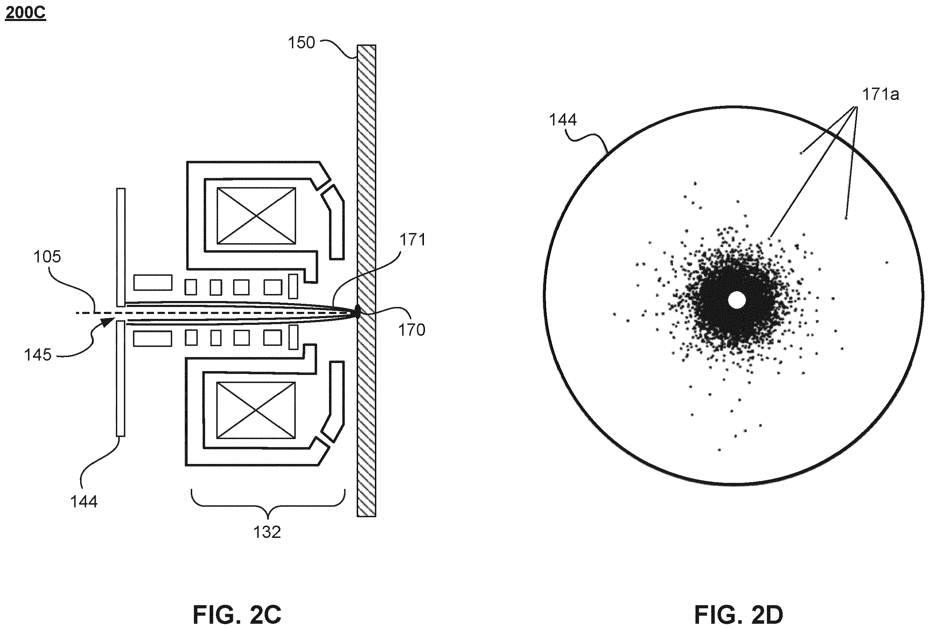

**Fig. 2C** illustrates an example of a charged particle beam apparatus 200C, consistent with embodiments of the present disclosure. Charged particle beam apparatus 200C may be, e.g., charged particle beam apparatus 200A of **Fig. 2A** or 200B of **Fig. 2B****.** Emitted electrons 171, comprising e.g., secondary or backscattered electrons, are emitted from the wafer surface by the impingement of electrons of the primary electron beam 105. A retarding electric field, which may slow the primary electrons as they approach probe spot 170, may act as an acceleration electric field to accelerate the emitted electrons backwards toward a PIN detector 144 surface. For example, as shown in **Fig. 2C****,** due to interactions with wafer 150 at probe spot 170, emitted electrons 171 may be generated that travel back toward detector 144. Emitted electrons 171 from the wafer surface travelling along optical axis 105 may arrive at the surface of detector 144 with a distribution of positions. The landing positions of emitted electrons may be within a generally circular region with a radius of, for example, a few millimeters. A geometric spread of landing positions of emitted electrons may be due to electrons having different trajectories that may be dependent on, for example, initial kinetic energy and emission angles of the electrons. Other factors may affect a geometric spread, or other characteristics, of landing positions. These factors are discussed below with respect to embodiments of the present disclosure.

**Fig. 2D** illustrates an example of an emitted electron landing point distribution on a detector surface. Electrons 171a may land at different points on the surface of detector 144 while, generally, most may be clustered around the central portion of detector 144 when there is no deflection field. As discussed above, emitted electrons may comprise, e.g., secondary or backscattered electrons. In some embodiments, for example, a distribution may comprise between 60-85% secondary electrons and between 40-15% backscattered electrons. The landing point distribution may shift depending on emission position and SEM deflection fields (e.g., scan field). Therefore, in some applications, if a certain field of view (FOV) of a SEM image is required, the required size of an in-lens PIN detector may be substantially large. Typically, a detector may be 10 mm in diameter, or larger, for example. In some embodiments, a detector may be, e.g., about 4 to 10 mm in diameter.

Detector 144 may be placed along optical axis 105. The primary electron beam may be configured to travel along optical axis 105. Accordingly, detector 144 may include a hole 145 at its center so that the primary electron beam may pass through to reach wafer 150. **Figs. 2B-C** show examples of a detector 144 having an opening at its center. However, some embodiments may use a detector placed off-axis relative to the optical axis along which the primary electron beam travels. For example, as in the example shown in **Fig. 2A****,** a beam separator 222 may be provided to direct emitted electron beams toward a detector placed off-axis. Beam separator 222 may be configured to divert emitted electron beams by an angle α toward an electron detection device 244, as shown in **Fig. 2A****.** Therefore, in some embodiments of the present disclosure, a detector may be provided that has no central opening.

Detectors 244 of **Fig. 2A** or 144 of **Figs. 2B-D** or may include sensing elements such as diodes, or elements similar to diodes, that may convert incident energy into a measurable signal. For example, sensing elements in a detector may include a SPAD, APD, or PIN diode. Throughout this disclosure, sensing elements may be represented as a diode, although sensing elements or other components may deviate from ideal circuit behavior of electrical elements such as diodes, resistors, capacitors, etc. In embodiments of the present disclosure, a detector in a charged particle beam system may comprise a pixelated array of multiple sensing elements. The sensing elements may be configured for charged particle counting. Sensing elements of a detector that may be useful for charged particle counting are discussed in U.S. Publication No. 2019/0378682, which is incorporated by reference in its entirety.

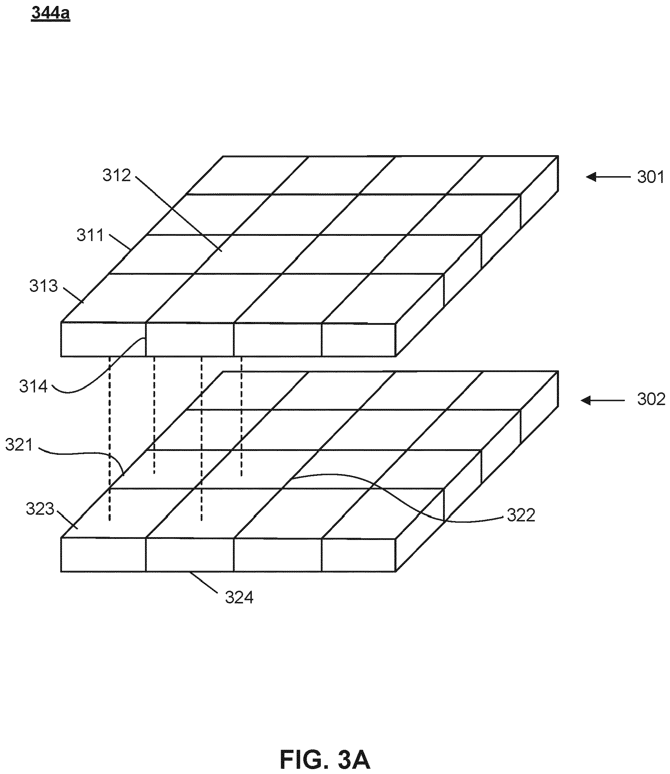

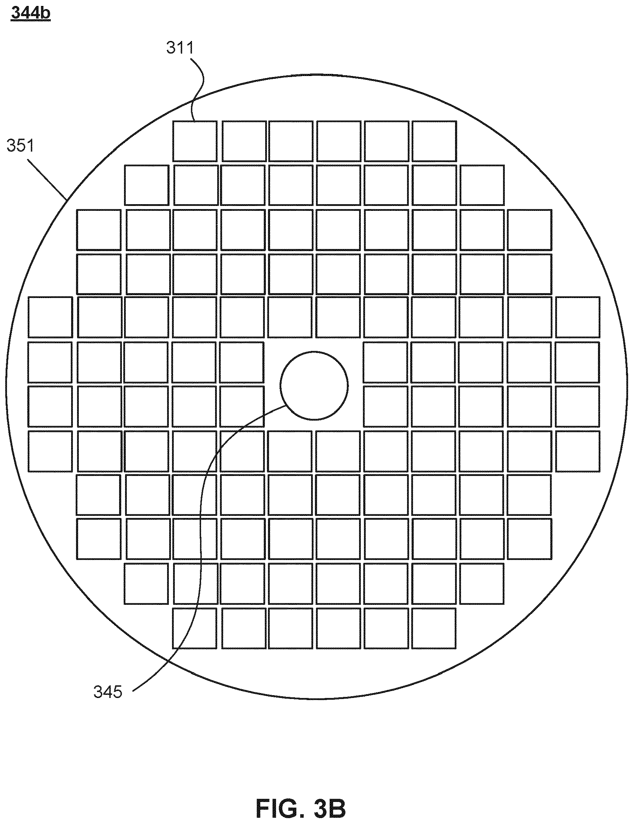

**Figs. 3A-B** illustrate exemplary structures of a pixelated electron counting detector (PECD), consistent with embodiments of the present disclosure. A detector such as detector 344a of **Fig. 3A** or 344b of **Fig. 3B** may be provided as detector 244 as shown in **Fig. 2A** or 144 as shown in **Figs. 2B-D****.** In **Fig. 3A****,** detector 344a includes a sensor layer 301 and a signal processing layer 302. Sensor layer 301 may include a sensor die made up of multiple sensing elements, including sensing elements 311, 312, 313, and 314. In some embodiments, the multiple sensing elements may be provided in an array of sensing elements, each of which may have a uniform size, shape, and arrangement.

Signal processing layer 302 may include multiple signal processing circuits, including circuits 321, 322, 323, and 324. The circuits may include interconnections (e.g., wiring paths) configured to communicatively couple sensing elements. Each sensing element of sensor layer 301 may have a corresponding signal processing circuit in signal processing layer 302. Sensing elements and their corresponding circuits may be configured to operate independently. As shown in **Fig. 3A****,** circuits 321, 322, 323, and 324 may be configured to communicatively couple to outputs of sensing elements 311, 312, 313, and 314, respectively, as shown by the four dashed lines between sensor layer 301 and signal processing layer 302.

In some embodiments, signal processing layer 302 may be configured as a single die with multiple circuits provided thereon. Sensor layer 301 and signal processing layer 302 may be in direct contact. In some embodiments, components and functionality of different layers may be combined or omitted. For example, signal processing layer 302 may be combined with sensor layer 301 into a single layer. Furthermore, a circuit for charged particle counting may be integrated at various points in a detector, for example in a separate read-out layer of a detector or on a separate chip. Further details of electron counting circuitry and alternative structures for sensor layer 301 and signal processing layer 302 may be found in International Publication WO 2022/008518, the entirety of which is incorporated herein by reference.

As shown in **Fig. 3B****,** a detector 344b having an array of sensing elements 311 may be provided. Detector 344b may be, e.g., a PECD. Detector 344b may include sensor layer 301 and signal processing layer 302 as seen in **Fig. 3A****.** Detector circuitry may include an electron counting circuit separately provided for each sensing element. Detector 344b may include a plate 351, wherein the plurality of sensing elements 311 are formed thereon. Plate 351 may include opening 345 for allowing a primary electron beam to pass through plate 351.

When an individual sensing element 311 of a detector is made small compared to the geometric spread of emitted electrons incident on the detector, individual electron counting may be achieved. For example, each sensing element may have its own counting unit comprising circuitries configured to measure an output signal from the sensing element. When sensing elements are made smaller, the rate of electron arrival at each sensing element is reduced, and thus electron counting at each sensing element may become enabled. Furthermore, the capacitance of a detector may be proportional to an area of a detector surface. Some sources of noise, such as that due to components being coupled to a detector (e.g., an amplifier), may be related to capacitance. The small area of each individual element in a PECD allows a much lower capacitance than, e.g., a large continuous sensing surface. For example, an individual sensing element may be a square or other shape having dimensions of, e.g. 5, 10, 25, 50, 100, 200, or 300 µm on a side. Sensing elements may be larger, e.g., on the order of millimeters. A typical detector may comprise, e.g., 100, 500, 1,000, 5,000, 10,000, 50,000 or 100,000 or more sensing elements.

Some charged particle beam processes, such as high-resolution SEM, require a very low primary beam current (e.g., down to 40 pA) and a high operation speed (e.g., 400 Mpixel per second). Such a low primary beam current results in a very small number of electrons incident on the detector. For example, an entire detector may record only a single electron event per clock cycle (2.5 ns = 1/400 MHz). With this low primary beam current, it becomes increasingly important to determine the likelihood that a recorded event is real, i.e., to have a very low rate of false positives.

Embodiments of the present disclosure utilize information about the locations of electron arrival events on the detector, in combination with reference distribution information in a charged particle beam process, to filter out false positives. The purpose of pixelation in a PECD detector is to increase the sensitivity of individual detection, not to gather spatial information or to generate an image. Filtering out a detection as a false positive may include, e.g., eliminating the detection entirely, or assigning a weighting coefficient according to a determined probability that the detection event is a false positive. For example, when a detection event is determined to have very low probability of being false (i.e., a high probability of being real), the detection event may be assigned a weighting coefficient equal or near to one. When a detection event is determined to have very high probability of being false (i.e., a low probability of being real), the detection event may be assigned a weighting coefficient equal or near to zero.

In some embodiments of the present disclosure, the reference distribution information may include historical information of an expected electron arrival location on a detector. The expected electron arrival location may be based on modeled or experimental data corresponding to the conditions of the charged particle beam process. Conditions may include structural, operational, or other measurable parameters of a charged particle beam apparatus. For example, the historical information may include electrode voltages, beam currents, or spatial or structural configurations of components of the charged particle beam apparatus. The historical information may include topographical or other information about a sample being processed, such as a wafer under SEM inspection. The historical information may include a location of a beam spot (a sample pixel) in a field of view (FOV) of the charged particle beam apparatus.

In some embodiments of the present disclosure, the reference distribution information may include measurement information from spatially separated measurements. For example, the measurements of two adjacent inspection pixels may be compared to determine the likelihood that electron arrival events are real or false.

In some embodiments of the present disclosure, the reference distribution information may include another measurement frame of the same measurement pixel. That is to say, the reference distribution information may include measurements that are separated in time rather than space. By comparing multiple measurement frames of the same inspection pixel, outliers may be determined to have a greater likelihood of being a false positive.

In some embodiments of the present disclosure, the reference distribution information in the charged particle beam process may include derived information from the locations of electron arrival events on the detector itself. For example, rather than comparing detection results to historical information or other measurements, the detection information may be analyzed on its own to assign a weighting coefficient. The weighting may be assigned based on, e.g., clustering algorithms, least squares or other spatial distribution analyses.

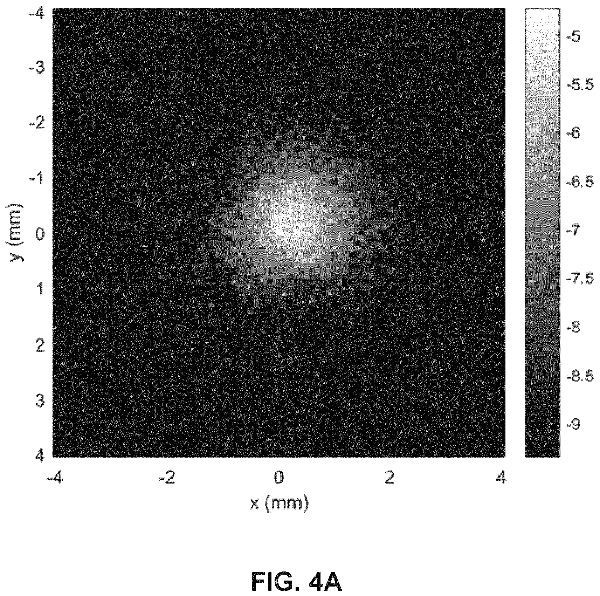

**Fig. 4A** illustrates historical information of an expected electron arrival location in an example method for filtering false positives, consistent with some embodiments of the present disclosure. **Fig. 4A** illustrates a spatial distribution of emitted electron landing points as detected at each detection pixel of a pixelated a detector. The detector may be, e.g., detector 244 of **Fig. 2A****,** 144 of **Figs. 2B-D****,** 344a of **Fig. 3A** or 344b of **Fig. 3B****.** Many parameters of the charged particle beam system may affect characteristics of a emitted electron landing point distribution, such as its geometric spread, symmetry, shape, centroid location, density gradient, etc. These parameters may generally be known in advance.

Some structural or operational settings of a charge particle beam system can impact the distribution of emitted electron landing positions. For example, the distance of a detector from a sample surface can affect the spread of a emitted electron beam, and thus the distribution of landing positions. A higher detector position can lead to a different distribution on the detector because the emitted electrons repel each other as they approach the detector surface. As another example, a larger landing energy of an electron on the sample surface can lead to a stronger magnetic objective lens, and thereby can lead to a larger divergence as the emitted electrons move toward the detector.

Electrode voltages may also impact the distribution. A higher voltage at, e.g., an electron extraction electrode, can lead to a smaller divergence as the emitted electrons move towards the detector, and thus leads to a narrower distribution.

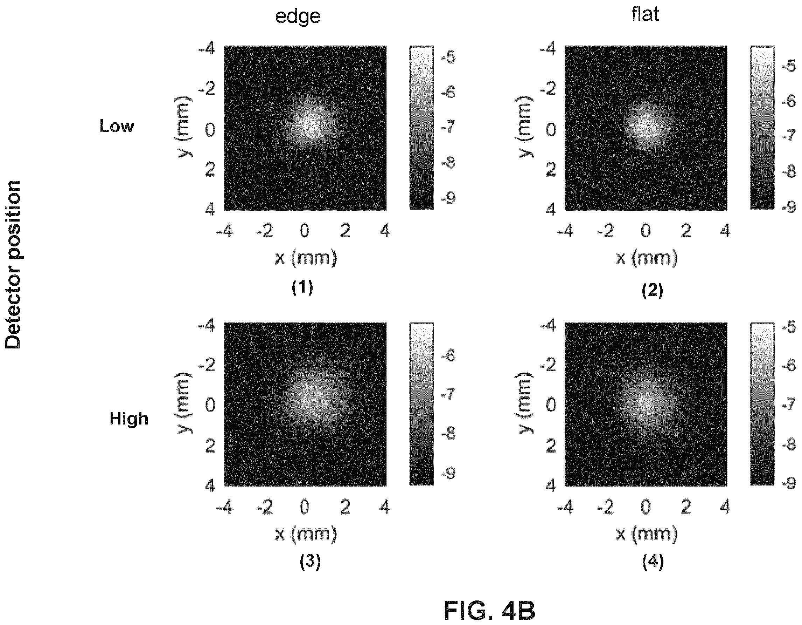

**Fig. 4B** illustrates further historical information of an expected electron arrival location in an example method for filtering false positives, consistent with some embodiments of the present disclosure. In addition to structural or operational parameters of the charged particle beam system, a emitted electron distribution may be affected by topography of the sample being processed. For example, circuit patterns on a semiconductor wafer may have various features such as trenches, ridges, holes, lines, edges, slopes and flat regions that can affect the trajectories of their emitted emitted electrons. **Fig. 4B** shows a 2x2 matrix of emitted electron landing point distributions (1)-(4) that vary by detector height and wafer topography. The top and bottom rows show distributions for a detector height of 105 nm and 160 nm, respectively. The left and right columns show distributions when a sample pixel occurs at an edge feature vs. a flat region, respectively. As can be seen in distribution (1) an electron distribution can be smaller for a lower detector height. But if the sample pixel under inspection contains, e.g., an edge feature, the distribution may be decentered from the detector, and some deformation may be introduced. As seen at distribution (2), an electron distribution for a lower detector height and flat topography can be tight, symmetrical, and centered on the detector surface. At distribution (3), when the same topography as distribution (2) is inspected with a larger detector height, the electron distribution spreads out but remains fairly centered and symmetrical. At distribution (4), a large detector height at an edge topography can yield a distribution that is more spread out than distribution (2), and more deformed and decentered than distribution (1). As discussed below, decentering and deformation may also occur depending on the location of a sample pixel within a field of view of the charged particle beam system.

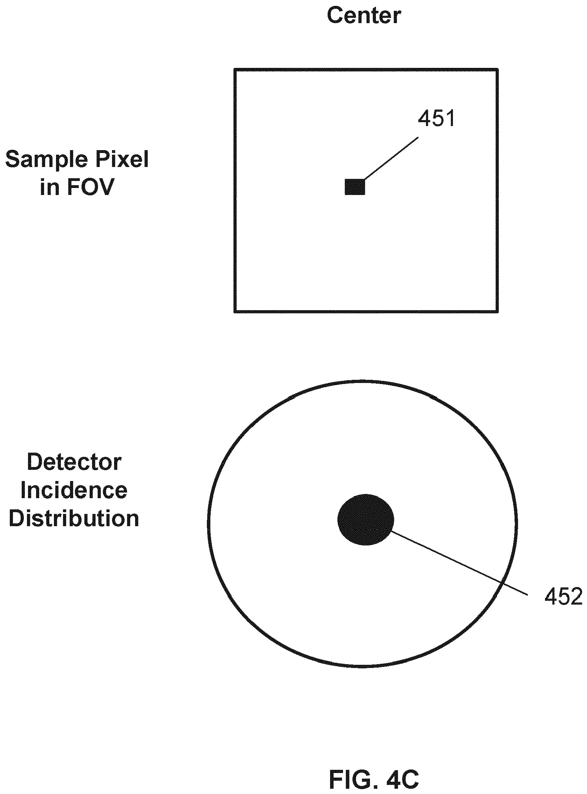

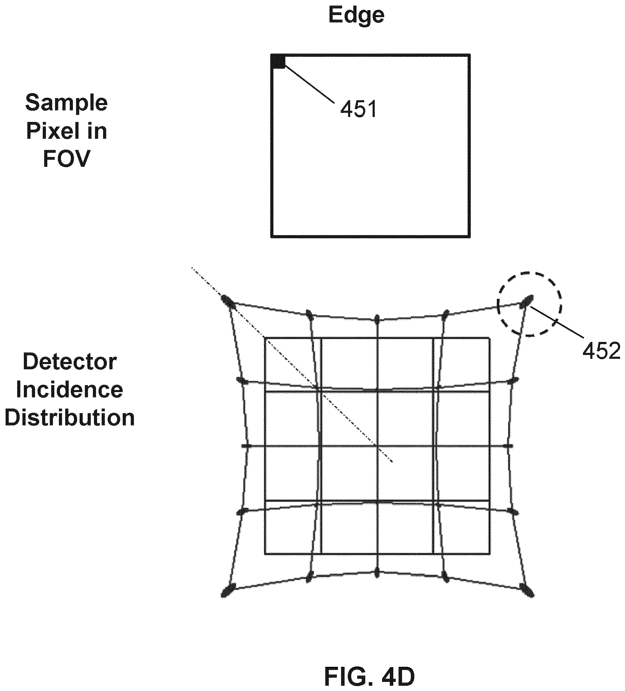

**Figs. 4C-D** illustrate further historical information of an expected electron arrival location in an example method for filtering false positives, consistent with some embodiments of the present disclosure. **Figs. 4C-D** show the relationship between the position of a sample pixel within the FOV of a charged particle beam system, and the resultant emitted electron landing point distribution. A primary electron beam is deflected by deflection electrodes to scan the beam across a plurality of sample pixels 451 in the FOV. The deflection electrodes may be, e.g., scanning unit 226 of **Fig. 2A** or deflector 132c of **Fig. 2B****.** This deflection increases with increasing distance from a center of the FOV, resulting in electron distributions that are more spread out, more deformed, and more decentered on the detector surface. For instance, **Fig. 4C** shows a sample pixel 451 exposed at a center of the FOV. The resultant emitted electron landing point distribution 452 is also centered. When a sample pixel 451 is at an edge of the FOV, as seen in **Fig. 4D****,** the emitted electron landing point distribution 452 is skewed off center and deformed.

Historical information, such as that which is discussed above with respect to **Figs. 4A-D****,** may be used to determine an expected location of real electron counts for a specific charged particle beam processes. For example, a memory may store a library of different expected electron landing distributions for various combinations of settings and conditions. Each expected electron landing distribution may be referred to as an expected incidence location map. The expected incidence location maps may be constructed from, e.g., modeled or experimental data corresponding to the conditions of the charged particle beam process. The memory may be, e.g., a part of controller 109. The memory may be storage 130 as shown in **Fig. 2B****.** When an electron landing distribution is measured on a detector during a charged particle beam process, the measurement may be stored as a spatial counts map from the detector. The spatial counts map may be compared to an appropriate expected incidence location map from the library. Using the comparison, a weighting coefficient may be applied to each count from the spatial counts map prior to summing the counts to generate a detection output for the sample pixel. The weighting coefficient may be calculated based on a probability that the detected count is real. The weighting coefficient may be, e.g., equal or near to one at a central portion of the distribution in an expected incidence location map. The weighting may be equal or near to zero at positions far from the central portion.

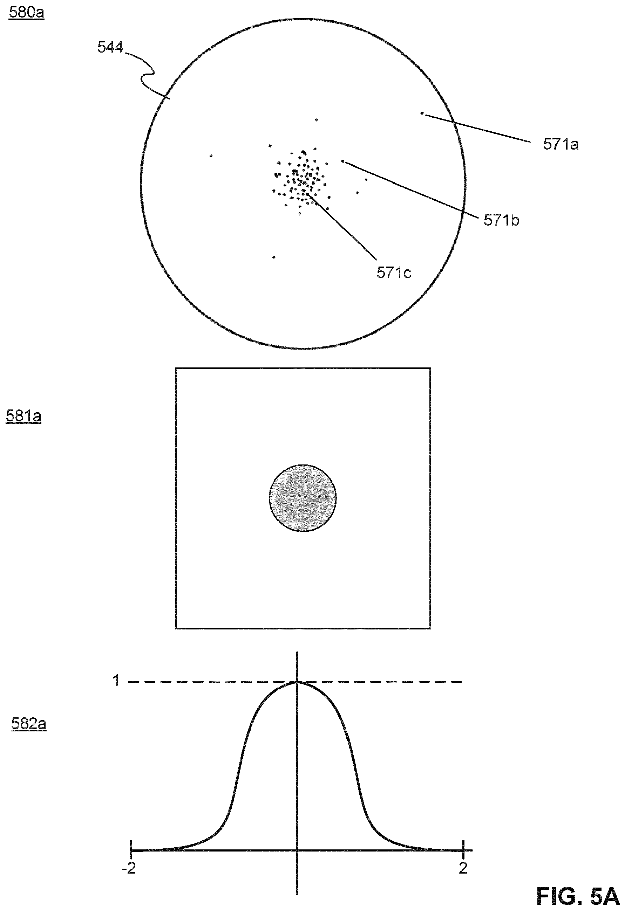

**Figs. 5A-C** illustrate example weighting distributions 582a-c for different spatial counts maps 580a-c in a charged particle beam process, consistent with some embodiments of the present disclosure. A spatial counts map may be the summation a plurality of short electron collection periods, or frames, to yield information of a single measurement pixel. For instance, a single frame may comprise, e.g., between 0 and 100 detected electron landing events, and the summation may include, e.g., between 4 and 200 frames. In some embodiments of the present disclosure, a spatial counts map may comprise, e.g., between twenty-five and several hundred or more detected electron landing events.

In **Fig. 5A****,** spatial counts map 580a of detected electron landing events 571 is displayed along with an expected incidence location map 581a and cross-sectional weighting distribution 582a. Spatial counts map 580a may be centered on detector 544 due to, e.g., a low aberration of the primary electron beam, the measurement occurring near a center of the FOV, etc. A shape, geometric spread and other characteristics of the spatial counts map may be influenced by other factors as discussed above. Expected incidence location map 581a may be selected from a library based on at least some of these factors and compared to spatial counts map 580a. A weighting coefficient may be applied to each count within spatial counts map 580a based on the comparison. The resulting weighting distribution 582a is shown. According to weighting distribution 581a, detected electron landing event 571a has a lower likelihood of being an actual electron landing event. This event is given a lower weighting coefficient, e.g., at or near zero. Detected electron landing event 571b is at an intermediate region and may be assigned an intermediate weighting coefficient, e.g., between zero and 1. Detected electron landing event 571c is at central region where detected electron landing events are most likely to represent actual electron landing events. It may be assigned a higher weighting coefficient, e.g., at or near 1. After the weighting coefficients are assigned, the counts may be summed. In this way, false positives may have a lesser impact on a charged particle beam process.

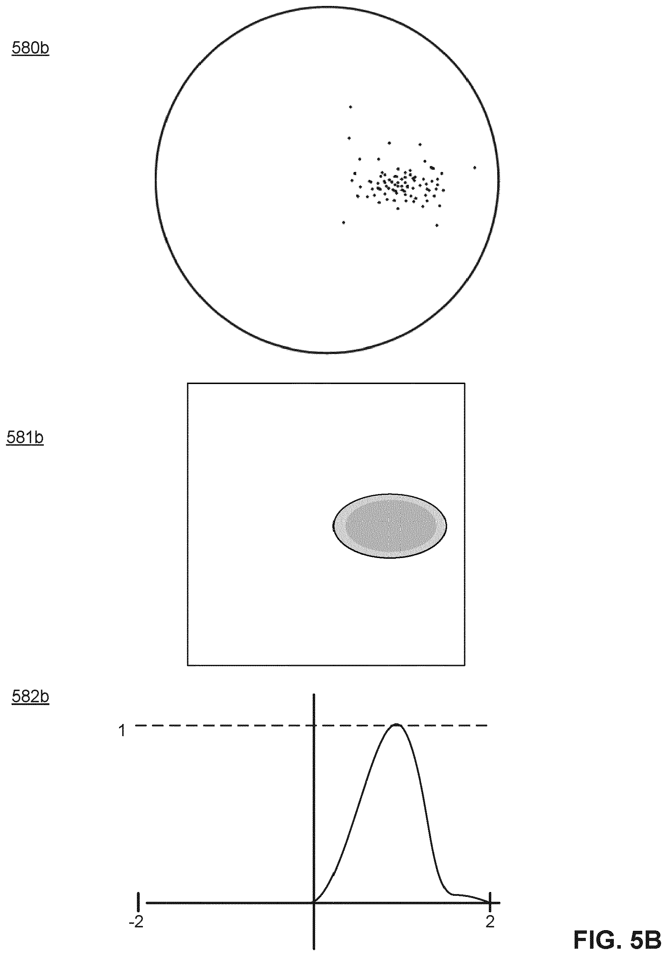

**Fig. 5B** illustrates another example weighting distribution 582b for spatial counts map 580b in a charged particle beam process, consistent with some embodiments of the present disclosure. **Fig. 5B** differs from **Fig. 5A** in that spatial counts map 580b is more decentered and deformed due to different parameters in the charged particle beam process. For instance, spatial counts map 580b may be from an entirely different charged particle beam process than spatial counts map 580a, that is configured with different voltage values, detector heights, etc. Alternatively, spatial counts map 580b could be a second measurement from the same process as 580a. In this case, the differences may result from, e.g., differences in topography or FOV location of the measured sample pixel. Nevertheless, the weighting process in **Fig. 5B** may be similar to that in **Fig. 5A****.** An appropriate expected incidence location map 581b may be selected from a library and compared to spatial counts map 580b. Detected electron landing events are weighted according to the likelihood that they represent actual electron landing events, and the weighted counts are summed to generate detection output.

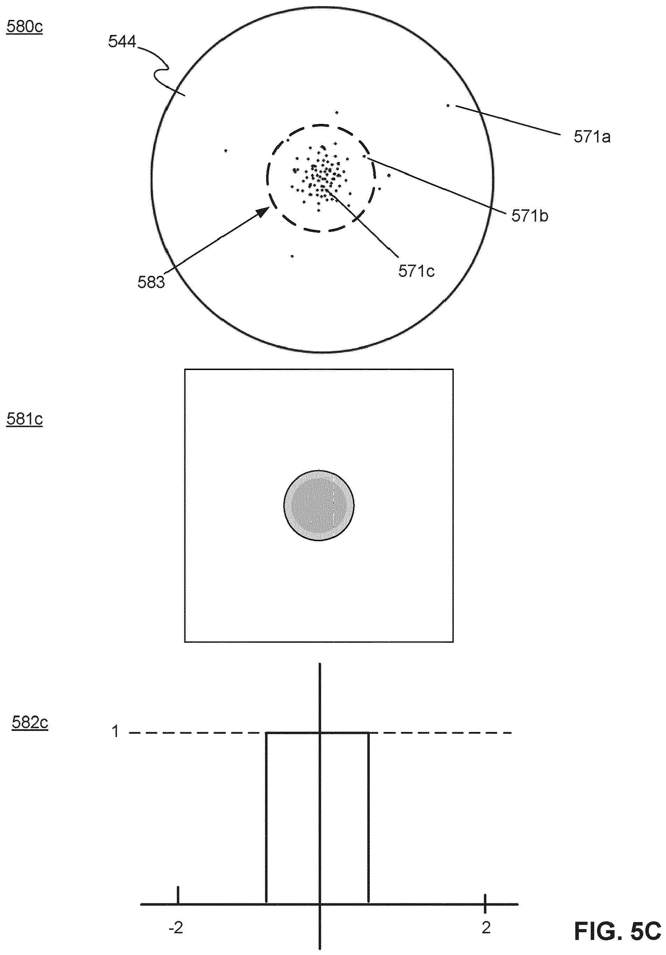

**Fig. 5C** illustrates another example weighting distribution 582c for spatial counts map 580c in a charged particle beam process, consistent with some embodiments of the present disclosure. **Fig. 5C** differs from **Figs. 5A** **&** **5B** in that the weighting distribution is discontinuous. Spatial counts map 580c and expected incidence location map 581c of **Fig. 5C** may be, e.g., spatial counts map 580a and expected incidence location map 581a of **Fig. 5A****.** However, in this case, the comparison is used to determine a spatial threshold 583. Detected electron landing event 571a, located outside spatial threshold 583, may be assigned a lower weighting coefficient, e.g., zero. Detected electron landing events 571b-c, located inside spatial threshold 583, may be assigned a higher weighting coefficient, e.g., one. In this way a simple calculation may be used to eliminate entirely those detected events that have a higher likelihood of being a false count. A simpler calculation may also make it easier to keep up with a high data input rate of, e.g., 400 MHz or more.

The discontinuous weighting distribution of **Fig. 5C** need not be binary, and the assigned values need not be one and zero. In some embodiments of the present disclosure, electron landing events 571a located outside a threshold 583 may be assigned a value of, e.g., 0.5. There may be multiple thresholds 583 created to assign multiple values between zero and one. The weighting distribution 582c in a multiple-threshold embodiment may take the form of, e.g., a stepped profile. The multiple thresholds 583 may be concentric or have a same geometry. Alternatively, multiple thresholds 583 may have different geometries, or they may have centroids that are displaced from each other.

In some embodiments, reference distribution information other than historical information is used as a comparison to determine a weighting distribution. For example, instead of comparing a spatial counts map to an expected incidence location map, a set of spatial counts maps may be compared to each other based on an expected similarity between them. A set of spatial counts maps may have an expected similarity, if, e.g., they come from adjacent sample pixels, or if they are different measurement frames of the same measurement pixel.

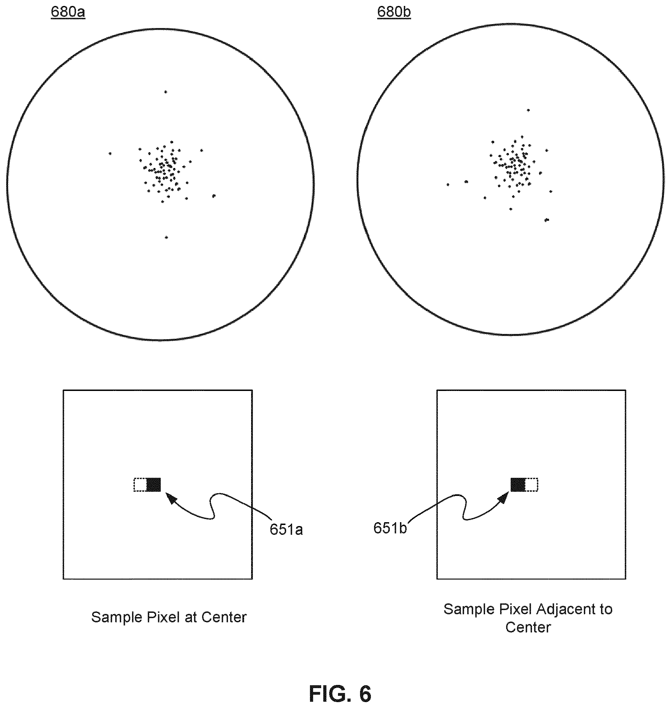

**Fig. 6** illustrates an example comparison of two spatial counts maps 680a-b, consistent with some embodiments of the present disclosure. Spatial counts map comparisons may be used to determine a weighting distribution similarly to the expected incidence location map comparisons discussed above with respect to the embodiments of **Figs. 5A-C****.**

In **Fig. 6****,** a first spatial counts map 680a from a first sample pixel 651a is compared to a second spatial counts map 680b from a second sample pixel 651b. The sample pixels are chosen for comparison based on an expected similarity between the first and second spatial counts maps. The expected similarity may be due to, e.g., proximity of the first and second sample pixels. For example, a first sample pixel 651a may be a sample pixel at the center of a FOV of the charged particle beam system, and a second sample pixel may be immediately adjacent the first. Alternatively, a second sample pixel may be within a prescribed number of pixels of the first, if their proximity still yields an expected similarity within acceptable limits.

The number of spatial counts maps need not be limited to two. Any number of spatial counts maps 680 may be compared to each other in order to determine a weighting distribution for each spatial count map. Furthermore, the comparison need not be made between complete maps. Partial maps (e.g., a set of frames) may also be used as reference information. The set of frames may be less than the full set of frames used to create a spatial counts map. For instance, if a second spatial counts map 680b from second pixel 651b comprises 200 frames, a subset of 4-100 frames, for example, may be used as the reference information.

In some embodiments of the present disclosure, a set of spatial counts maps, such as 680a-b, are compared to each other simultaneously, and a weighting distribution for each is determined by comparison to the other. However, this need not always be the case. For example, a newly acquired spatial counts map may be compared to, e.g., a most recently acquired proximal spatial counts map. The most recently acquired spatial counts map may have already undergone its own filtering process to identify false positives. The most recently acquired spatial counts map may be stored at least temporarily, in raw or filtered from, for comparison to the newly acquired spatial counts map. A series of spatial counts map comparisons may be updated continuously during a charged particle beam process. In this way, each sample pixel is processed in succession as detection data is received to better keep pace with a high data input rate. When the most recently acquired spatial counts map is not proximal to the newly acquired spatial counts map, such as when transitioning to a new scan line or a new FOV, the newly acquired spatial counts map may be compared to, e.g., a proximal spatial counts map that has been previously stored for that purpose.

It is further noted that an expected similarity could be based on factors other than spatial proximity. For example, a set of spatial counts maps 680 may be compared to each other based on an expected similar topography, FOV position, etc. As further discussed below, the proximity may be temporal in addition to spatial.

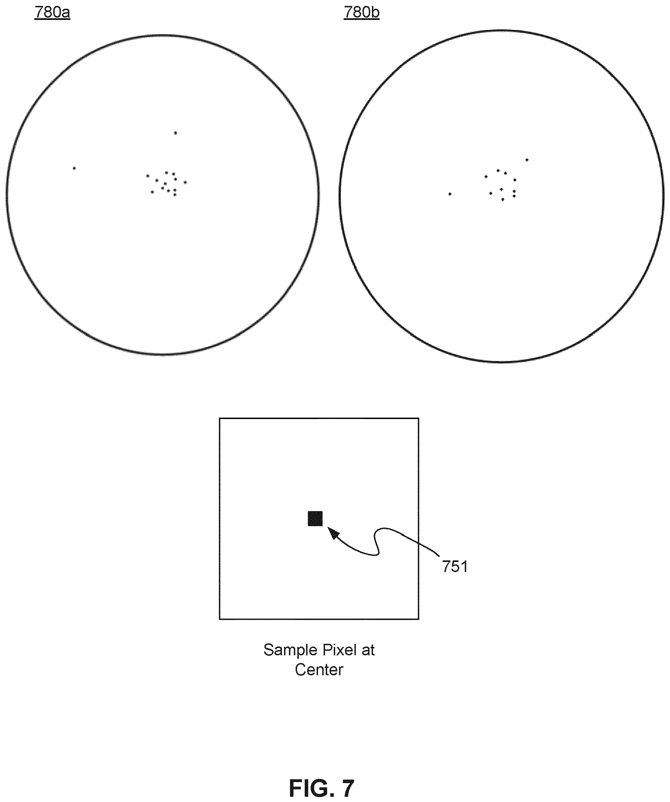

**Fig. 7** illustrates an example comparison of two spatial counts maps 780a-b, consistent with some embodiments of the present disclosure. In **Fig. 7****,** a first spatial counts map 780a and a second spatial counts map 780b are each constructed from different frames of the same sample pixel 751. By comparing multiple frames from the same sample pixel, a "frame averaging" effect may allow for effective identification of false positives in a charged particle beam process. The number of frames used for creation of an image pixel from a sample pixel may range from, e.g., a few frames up to hundreds of frames, so that sufficient frames may be available for a temporal comparison.

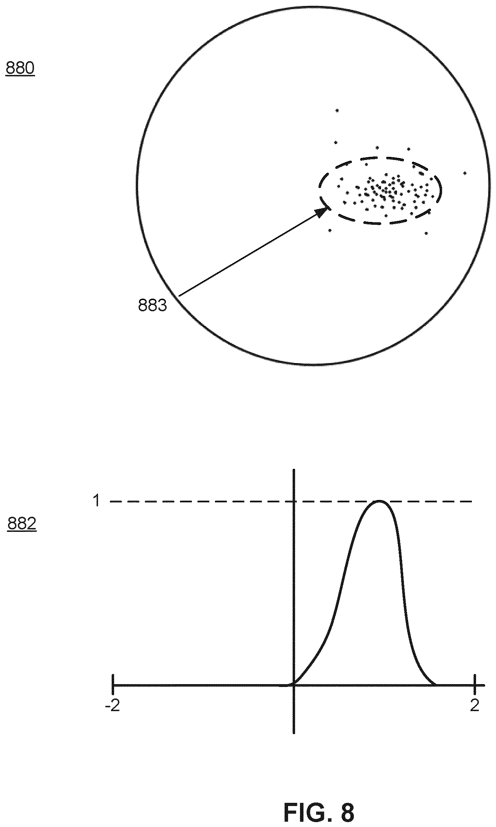

In some embodiments of the present disclosure, reference distribution information in the charged particle beam process may be derived information from the spatial counts map itself. **Fig. 8** illustrates an example weighting distribution 882 for spatial counts map 880 in a charged particle beam process, consistent with some embodiments of the present disclosure. Spatial counts map 880 may not be compared to an expected incidence location map, or to similar spatial counts map from a spatially or temporally adjacent sample pixel. Instead, spatial counts map 880 is analyzed with respect to its own data. By determining spatial information such as, e.g., a central clustering of an emitted electron landing point distribution, a weighting distribution may be assigned. The determination of spatial information may be based on, e.g., clustering algorithms, least squares or other spatial distribution analyses, image or pattern recognition, comparison to a library of basic geometric shapes, etc. In some embodiments of the present disclosure, a spatial threshold 883 may be generated based on a spatial analysis of the detected emitted electron landing point distribution. This spatial threshold may be used as a comparison in a manner similar to, e.g., the expected incidence location maps 581a-c of **Figs. 5A-C****,** adjacent spatial counts maps 680a-b of **Fig. 6****,** or the frame averaging spatial counts maps 780a-b of **Fig. 7****.** For example, spatial threshold 883 may be used to assign a continuous, binary, stepped or other weighting distribution.

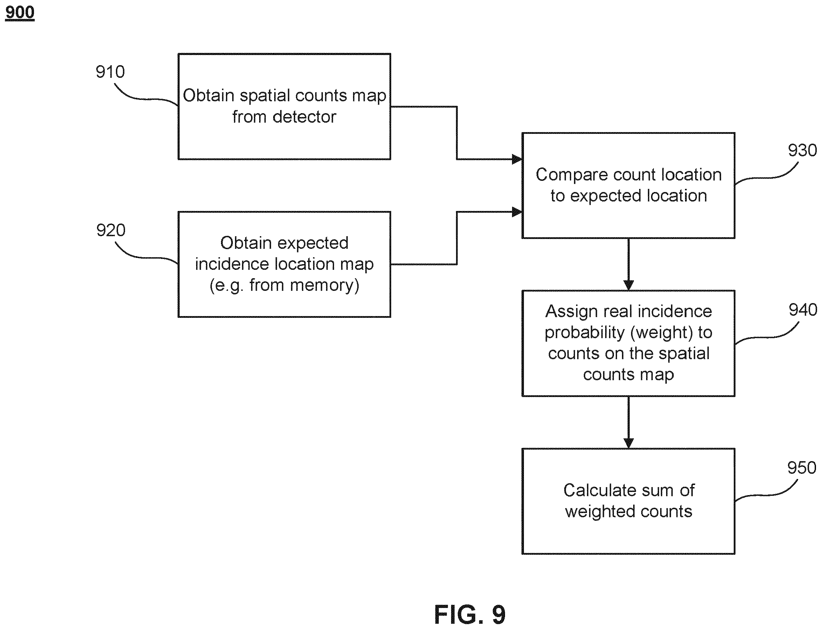

Additionally, derived information may be used to assign weights to a single frame or a set of multiple frames. For example, a frame with 10 or more detected electron landing events may be sufficient to determine adequate spatial information of the electron landing point distribution**.****Fig. 9** illustrates a flowchart of an example method 900 of filtering false positives in a charged particle beam detector, consistent with some embodiments of the present disclosure. The charged particle beam detector may be part of a charged particle beam apparatus. For example, the charged particle beam detector may be a PECD in a SEM used for inspection of a sample such as a semiconductor wafer. The method may be carried out by a processor and memory of a controller configured to control the charged particle beam apparatus to perform the method.

At step 910, a spatial counts map is obtained from a detector. The detector may be, e.g., detector 244 of **Fig. 2A****,** detector 144 of **Figs. 2B-D****,** detector 344a of **Fig. 3A****,** detector 344b of **Fig. 3B****,** or any charged particle detector capable of yielding spatial information to generate a spatial counts map.

The spatial counts map may detail the spatial locations of detected electron landing events on the detector for a sample pixel on a sample in a field of view (FOV) of the charged particle beam apparatus. The spatial counts map may be, e.g., similar to maps 580a-c of **Figs. 5A-C****,** 680a-c of **Fig. 6****,** 780a-b of **Fig. 7****,** 880 of **Fig. 8****.** In general, the spatial counts map may provide information that relates detected electron landing events to the locations on a detector at which the lending events were detected.

At step 920, an expected incidence location map is obtained, e.g., from a memory. The expected incidence location map may be selected from a library of expected incidence location maps. The expected incidence location map may provide information about an expected distribution of real electron landing events on the detector. The expected distribution may be based on conditions that correspond to the charged particle beam process and the sample pixel. For example, conditions of the charge particle beam process may include placement of detectors and other components, voltage values of electrodes, primary electron beam characteristics, spot location within a FOV, any other parameters that were detailed above, or any parameters that are generally known in the art to have an appreciable effect on the charged particle beam process. Conditions of the sample pixel may include, e.g., topographical or material characteristics at the sample pixel location.

At step 930, the count locations in the spatial counts map are compared to expected incidence locations on the expected incidence location map. The comparison may be carried out by, e.g. a fitting algorithm configured to assign a value to each detected electron landing event as a function of how well it conforms to a distribution in the expected incidence location map. The expected incidence location map be, e.g., expected incidence location maps 581a-c of **Figs. 5A-C****.** The library may store any number of expected incidence location maps corresponding to the various potential combinations of conditions and parameters discussed above.

At step 940, each detected electron landing event in the spatial counts map is assigned a weighting coefficient according to a probability that the detected event represents and actual electron landing event. The weighting coefficient is determined based on the comparison at Step 930. A weighting coefficient may be, e.g., equal or close to the value of one at a central portion of the distribution in an expected incidence location map. The weighting may be equal or close to zero at positions farther out from the central portion. The collection of all weighting coefficients may be represented as a weighting coefficient distribution over the spatial counts map. The weighting coefficient distribution may be continuous, binary, stepped, etc. The distribution may have a gaussian shape, a 2-dimensional t-distribution, a sharp peak, or any other shape that corresponds to the assignment of weighting coefficients in step 940. Weighting coefficients may be distributed as shown at, e.g., 582a-c of **Figs. 5A-C** or 882 of **Fig. 8****.** In some embodiments, the step 930 of comparing locations and the step 940 of assigning weighting coefficients may be a singular and simultaneous operation.

At step 950, the weighted counts are summed to yield a detection output for the sample pixel. The detection output may be used to construct an image pixel representing the sample pixel in an image of the sample. For example, the image pixel may be a pixel of a SEM image of a semiconductor wafer.

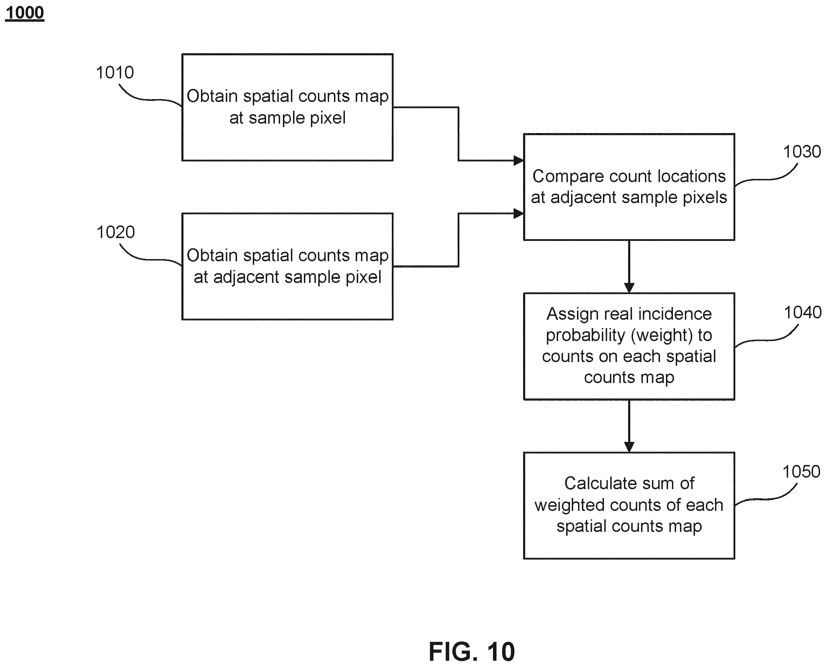

**Fig. 10** illustrates an example method 1000 of filtering false positives in a charged particle beam detector, consistent with some embodiments of the present disclosure. The charged particle beam detector may be part of a charged particle beam apparatus. For example, the charged particle beam detector may be a PECD in a SEM. The method may be carried out by a processor and memory of a controller configured to control the charged particle beam apparatus to perform the method. The method 1000 is similar to method 900 except as described below.

At step 1010 a spatial counts map is obtained in a manner similar to step 910 of method 900. The spatial counts map is a first spatial counts map of a first sample pixel.

At step 1020, a second spatial counts map of a second sample pixel is obtained in a manner similar to the first. The second sample pixel may be adjacent, or near to, the first sample pixel. The first sample pixel and the second sample pixel may have an expected similarity due to their proximity. The first sample pixel and the second sample pixel may have an expected similarity due to other factors, such as an expected similarity of sample pixel topography or material, or a similarity of location within a charged particle apparatus FOV. While only two spatial counts maps are shown in method 1000, it should be understood that any number of spatial counts maps may be collected in in steps 1010 and 1020.

At step 1030, the count locations of the first and second spatial counts maps may be compared in a manner similar to the comparison in step 930 of method 900. However, instead of comparing a spatial counts map to an expected incidence location map, the first and second spatial counts maps are directly compared to each other. Because the first and second spatial counts maps are expected to yield a similar distribution of real electron landing events, the comparison may indicate a probability that non-conforming or outlier electron landing events within either spatial counts map may be false positives. Again, as discussed above with respect to steps 1010 and 1020, this comparison is not limited to two spatial counts maps.

At step 1040, each detected electron landing event in the first and second spatial counts map is assigned a weighting coefficient according to a probability that the detected event represents and actual electron landing event. The weighting coefficient is determined based on the comparison at step 1030, and may result in a number of possible weighting distributions as discussed with respect to step 930 of method 900 above. The comparison of spatial counts maps and assignment of weighting distributions need not be applied to the first and second spatial counts maps simultaneously. As discussed above with respect to Fig. 6, for example, each acquired spatial counts map may be compared in succession to, e.g., a most recently acquired proximal spatial counts map.

At step 1050, the weighted counts of first and second spatial counts maps may be summed to yield first and second detection outputs for the first and second sample pixels. The first and second detection outputs may be used to construct first and second image pixels representing the first and second sample pixels in an image of the sample. For example, the first and second image pixels may be pixels of a SEM image of a semiconductor wafer.

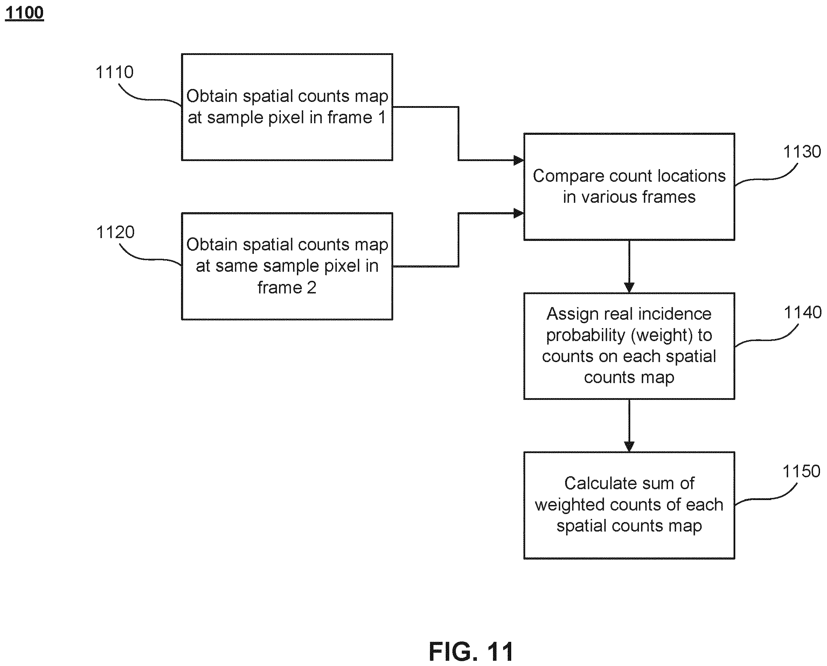

**Fig. 11** illustrates an example method 1100 of filtering false positives in a charged particle beam detector, consistent with some embodiments of the present disclosure. The charged particle beam detector may be part of a charged particle beam apparatus. For example, the charged particle beam detector may be a PECD in a SEM. The method may be carried out by a processor and memory of a controller configured to control the charged particle beam apparatus to perform the method. The method 1100 is similar to method 1000 except as described below.

At step 1110 a spatial counts map is obtained in a manner similar to step 1110 of method 900. The spatial counts map is a first spatial counts map of a first frame of a sample pixel.

At step 1120, a second spatial counts map of a second frame of the same sample pixel is obtained in a manner similar to the first. The second frame may be a collection of detected electron landing events that are not coextensive in time with the first frame. The second sample pixel may be a second . While only two spatial counts maps from two frames are shown in method 1100, it should be understood that any number of spatial counts maps from any number of frames may be collected in in steps 1110 and 1120.

At step 1130, the count locations of the first and second spatial counts maps may be compared in a manner similar to the comparison in step 1030 of method 1000. However, instead of comparing first and second spatial counts maps from different pixels, first and second spatial counts maps from different frames of the same sample pixel are directly compared to each other. Because the first and second frames are expected to yield a similar distribution of real electron landing events, the comparison may indicate a probability that non-conforming or outlier electron landing events within either spatial counts map may be false positives. Again, as discussed above with respect to steps 1110 and 1120, this comparison is not limited to two spatial counts maps from two frames.

At step 1140, each detected electron landing event in the first and second spatial counts map is assigned a weighting coefficient according to a probability that the detected event represents and actual electron landing event. The weighting coefficient is determined based on the comparison at step 1130, and may result in a number of possible weighting distributions as discussed with respect to step 930 of method 900 and step 1030 of method 1000 above.

At step 1150, the weighted counts of first and second spatial counts maps may be summed to yield first and second detection outputs for the first and second frames. Data outputs from the first and second frames may likewise be combined with each other to yield a combined detection output representing the single sample pixel. For example, the combined detection output may be used to construct an image pixel representing the sample pixel in an image of the sample. For example, the image pixel may be a pixel of a SEM image of a semiconductor wafer.

The charged particle systems and methods above have at times been described with respect to emitted electrons. However, it should be understood that other charged particles, or other classes of electrons are contemplated within the scope of the present disclosure.

Furthermore, while some embodiments have been directed to filtering false positives, other uses are contemplated within the scope of the present disclosure. For example, some raw spatial counts maps, weighted maps, frames, etc. may be retained as stored information for diagnostic and monitoring purposes. A number of sample pixels from, e.g., each FOV may be stored. The stored information may be utilized to determine whether components of a charged particle beam system are functioning properly, or for other diagnostic and monitoring operations. For example, the stored information may be used to identify malfunctioning detector pixels, such as so-called "hot" pixels that tend to register false positives, or "dead" pixels that fail to register a real electron landing event. The stored information may be used to identify a sensitivity gradient across all or part of the detector surface. The stored information may be used to characterize beam parameters or electron optics parameters such as aberration, divergence, distortion or deflection errors. Based on the stored information, corrections, adjustments or maintenance operations may be determined and performed on a charged particle beam apparatus.

A non-transitory computer-readable medium may be provided that stores instructions for a processor of a controller (e.g., controller 109 in **Fig. 1****)** for filtering false positives consistent (such as the filtering techniques shown above in in **Figs. 9-11****)** with embodiments of the present disclosure. For example, the instructions stored in the non-transitory computer-readable medium may be executed by the circuitry of the controller for performing method 600 in part or in entirety. Common forms of non-transitory media include, for example, a floppy disk, a flexible disk, hard disk, solid-state drive, magnetic tape, or any other magnetic data storage medium, a Compact Disc Read-Only Memory (CD-ROM), any other optical data storage medium, any physical medium with patterns of holes, a Random Access Memory (RAM), a Programmable Read-Only Memory (PROM), and Erasable Programmable Read-Only Memory (EPROM), a FLASH-EPROM or any other flash memory, Non-Volatile Random Access Memory (NVRAM), a cache, a register, any other memory chip or cartridge, and networked versions of the same.

The embodiments may further be described using the following clauses:
1. A method comprising:
   obtaining spatial distribution information of detected charged particle incidence locations on a charged particle detector;
   comparing the spatial distribution information to reference distribution information; and
   assigning a value to a detected charged particle incidence location based on the comparison.
2. The method of clause 1, wherein the reference distribution information comprises expected incidence locations on the charged particle detector.
3. The method of clause 2, wherein the expected incidence locations are based on a charged particle beam parameter of a charged particle beam apparatus.
4. The method of clause 3, wherein the charged particle beam parameter comprises a primary beam parameter, a detector location, an electrode voltage, a charged particle landing energy, or a location of a sample pixel within a field of view of a charged particle beam apparatus.
5. The method of clause 2, wherein the expected incidence locations are based on a sample pixel parameter of a sample at a sample pixel location in a charged particle beam process.
6. The method of clause 5, wherein the sample pixel parameter comprises a material characteristic or topography of the sample at the sample pixel location.
7. The method of clause 5, wherein the sample is a semiconductor wafer.
8. The method of clause 1, wherein:
   the spatial distribution information comprises a first spatial counts map of a first sample pixel in a charged particle beam process; and
   the reference distribution information comprises a second spatial counts map of a second sample pixel in the charged particle beam process.
9. The method of clause 8, wherein the first sample pixel is adjacent to the second sample pixel.
10. The method of clause 8, wherein the reference distribution information further comprises a third spatial counts map of a third sample pixel in the charged particle beam process.
11. The method of clause 1, wherein:
   the spatial distribution information comprises a first frame of a spatial counts map of a sample pixel in a charged particle beam process; and
   the reference distribution information comprises a second frame of the spatial counts map of the sample pixel in the charged particle beam process.
12. The method of clause 1, wherein the value comprises a weighting coefficient.
13. The method of clause 12, wherein the weighting coefficient corresponds to a determined probability that the detected charged particle incidence location represents a real charged particle landing event.
14. The method of clause 1, further comprising:
   assigning a plurality of values to a plurality of detected charged particle incidence locations based on the comparison.
15. The method of clause 14, wherein the plurality of values comprises a plurality of weighting coefficients in a weighting coefficient distribution.
16. The method of clause 15, wherein the weighting coefficient distribution has a continuous profile, a binary profile, or a stepped profile.
17. The method of clause 15, wherein the plurality of weighting coefficients correspond to a plurality of determined probabilities that the plurality of detected charged particle incidence locations represent real charged particle landing events.
18. The method of clause 15, wherein:
   the spatial distribution information of detected charged particle incidence locations comprises a first detected charged particle incidence location and a second detected charged particle incidence location;
   the first detected charged particle incidence location is closer than the second detected charged particle incidence location to a centroid of the spatial distribution information; and
   a first weighting coefficient assigned to the first detected charged particle incidence location is greater than a second weighting coefficient assigned to the second detected charged particle incidence location.
19. The method of clause 15, further comprising:
   after assigning the plurality of weighting coefficients to the plurality of detected charged particle incidence locations to achieve a plurality of weighted detected charged article incidence locations, summing the plurality of weighted detected charged particle incidence locations; and
   generating a detector output based on the summed plurality of weighted detected charged particle incidence locations.
20. The method of clause 1, wherein the charged particle detector is an electron detector.
21. The method of clause 20, wherein the electron detector is a pixelated electron counting detector.
22. The method of clause 1, wherein the detected charged particle incidence locations are detected secondary electron incidence locations.
23. The method of clause 1, wherein the detected charged particle incidence locations are detected backscattered electron incidence locations.
24. A non-transitory computer-readable medium storing a set of instructions that are executable by at least one processor of a device to cause the device to perform a method comprising:
   obtaining spatial distribution information of detected charged particle incidence locations on a charged particle detector;
   comparing the spatial distribution information to reference distribution information; and
   assigning a value to a detected charged particle incidence location based on the comparison.
25. The non-transitory computer-readable medium of clause 24, wherein the reference distribution information comprises expected incidence locations on the charged particle detector.
26. The non-transitory computer-readable medium of clause 25, wherein the expected incidence locations are based on a charged particle beam parameter of a charged particle beam apparatus.
27. The non-transitory computer-readable medium of clause 26, wherein the charged particle beam parameter comprises a primary beam parameter, a detector location, an electrode voltage, a charged particle landing energy, or a location of a sample pixel within a field of view of an charged particle beam apparatus.
28. The non-transitory computer-readable medium of clause 25, wherein the expected incidence locations are based on a sample pixel parameter of a sample at a sample pixel location in a charged particle beam process.
29. The non-transitory computer-readable medium of clause 28, wherein the sample pixel parameter comprises a material characteristic or topography of the sample at the sample pixel location.
30. The non-transitory computer-readable medium of clause 28, wherein the sample is a semiconductor wafer.
31. The non-transitory computer-readable medium of clause 24, wherein:
   the spatial distribution information comprises a first spatial counts map of a first sample pixel in a charged particle beam process; and
   the reference distribution information comprises a second spatial counts map of a second sample pixel in the charged particle beam process.
32. The non-transitory computer-readable medium of clause 31, wherein the first sample pixel is adjacent to the second sample pixel.
33. The non-transitory computer-readable medium of clause 31, wherein the reference distribution information further comprises a third spatial counts map of a third sample pixel in the charged particle beam process.
34. The non-transitory computer-readable medium of clause 24, wherein:
   the spatial distribution information comprises a first frame of a spatial counts map of a sample pixel in a charged particle beam process; and
   the reference distribution information comprises a second frame of the spatial counts map of the sample pixel in the charged particle beam process.
35. The non-transitory computer-readable medium of clause 24, wherein the value comprises a weighting coefficient.
36. The non-transitory computer-readable medium of clause 35, wherein the weighting coefficient corresponds to a determined probability that the detected charged particle incidence location represents a real charged particle landing event.
37. The non-transitory computer-readable medium of clause 24, wherein the set of instructions that are executable by the at least one processor of the device cause the device to further perform:
   assigning a plurality of values to a plurality of detected charged particle incidence locations based on the comparison.
38. The non-transitory computer-readable medium of clause 37, wherein the plurality of values comprises a plurality of weighting coefficients in a weighting coefficient distribution.
39. The non-transitory computer-readable medium of clause 38, wherein the weighting coefficient distribution has a continuous profile, a binary profile, or a stepped profile.
40. The non-transitory computer-readable medium of clause 38, wherein the plurality of weighting coefficients correspond to a plurality of determined probabilities that the plurality of detected charged particle incidence locations represent real charged particle landing events.
41. The non-transitory computer-readable medium of clause 38, wherein:
   the spatial distribution information of detected charged particle incidence locations comprises a first detected charged particle incidence location and a second detected charged particle incidence location;
   the first detected charged particle incidence location is closer than the second detected charged particle incidence location to a centroid of the spatial distribution information; and
   a first weighting coefficient assigned to the first detected charged particle incidence location is greater than a second weighting coefficient assigned to the second detected charged particle incidence location.
42. The non-transitory computer-readable medium of clause 38, wherein the set of instructions that are executable by the at least one processor of the device cause the device to further perform:
   after assigning the plurality of weighting coefficients to the plurality of detected charged particle incidence locations to achieve a plurality of weighted detected charged article incidence locations, summing the plurality of weighted detected charged particle incidence locations; and
   generating a detector output based on the summed plurality of weighted detected charged particle incidence locations.
43. The non-transitory computer-readable medium of clause 24, wherein the charged particle detector is an electron detector.
44. The non-transitory computer-readable medium of clause 43, wherein the electron detector is a pixelated electron counting detector.
45. The non-transitory computer-readable medium of clause 24, wherein the detected charged particle incidence locations are detected secondary electron incidence locations.
46. The non-transitory computer-readable medium of clause 24, wherein the detected charged particle incidence locations are detected backscattered electron incidence locations.
47. A charged particle beam apparatus, comprising:
   a charged particle beam source configured to generate a beam of primary charged particles;
   an optical system configured to direct the beam of primary charged particles at a sample surface;
   a charged particle detector configured to detect a spatial distribution of detected charged particles returned from the sample surface;
   a controller configured to:
      obtain spatial distribution information of detected charged particle incidence locations on the charged particle detector;
      compare the spatial distribution information to reference distribution information; and
      assign a value to a detected charged particle incidence location based on the comparison.
48. The charged particle beam apparatus of clause 47, wherein the reference distribution information comprises expected incidence locations on the charged particle detector.
49. The charged particle beam apparatus of clause 48, wherein the expected incidence locations are based on a charged particle beam parameter of a charged particle beam apparatus.
50. The charged particle beam apparatus of clause 49, wherein the charged particle beam parameter comprises a primary beam parameter, a detector location, an electrode voltage, a charged particle landing energy, or a location of a sample pixel within a field of view of a charged particle beam apparatus.
51. The charged particle beam apparatus of clause 48, wherein the expected incidence locations are based on a sample pixel parameter of a sample at a sample pixel location in a charged particle beam process.
52. The charged particle beam apparatus of clause 51, wherein the sample pixel parameter comprises a material characteristic or topography of the sample at the sample pixel location.
53. The charged particle beam apparatus of clause 51, wherein the sample is a semiconductor wafer.
54. The charged particle beam apparatus of clause 47, wherein:
   the spatial distribution information comprises a first spatial counts map of a first sample pixel in a charged particle beam process of the charged particle beam apparatus; and
   the reference distribution information comprises a second spatial counts map of a second sample pixel in the charged particle beam process.
55. The charged particle beam apparatus of clause 54, wherein the first sample pixel is adjacent to the second sample pixel.
56. The charged particle beam apparatus of clause 54, wherein the reference distribution information further comprises a third spatial counts map of a third sample pixel in the charged particle beam process.
57. The charged particle beam apparatus of clause 47, wherein:
   the spatial distribution information comprises a first frame of a spatial counts map of a sample pixel in a charged particle beam process of the charged particle beam apparatus; and
   the reference distribution information comprises a second frame of the spatial counts map of the sample pixel in the charged particle beam process.
58. The charged particle beam apparatus of clause 47, wherein the value comprises a weighting coefficient.
59. The charged particle beam apparatus of clause 58, wherein the weighting coefficient corresponds to a determined probability that the detected charged particle incidence location represents a real charged particle landing event.
60. The charged particle beam apparatus of clause 47, wherein the controller is further configured to:
   assign a plurality of values to a plurality of detected charged particle incidence locations based on the comparison.
61. The charged particle beam apparatus of clause 60, wherein the plurality of values comprises a plurality of weighting coefficients in a weighting coefficient distribution.
62. The charged particle beam apparatus of clause 61, wherein the weighting coefficient distribution has a continuous profile, a binary profile, or a stepped profile.
63. The charged particle beam apparatus of clause 61, wherein the plurality of weighting coefficients correspond to a plurality of determined probabilities that the plurality of detected charged particle incidence locations represent real charged particle landing events.
64. The charged particle beam apparatus of clause 61, wherein:
   the spatial distribution information of detected charged particle incidence locations comprises a first detected charged particle incidence location and a second detected charged particle incidence location;
   the first detected charged particle incidence location is closer than the second detected charged particle incidence location to a centroid of the spatial distribution information; and
   a first weighting coefficient assigned to the first detected charged particle incidence location is greater than a second weighting coefficient assigned to the second detected charged particle incidence location.
65. The charged particle beam apparatus of clause 61, wherein the controller is further configured to:
   after assigning the plurality of weighting coefficients to the plurality of detected charged particle incidence locations to achieve a plurality of weighted detected charged article incidence locations, sum the plurality of weighted detected charged particle incidence locations; and
   generate a detector output based on the summed plurality of weighted detected charged particle incidence locations.
66. The charged particle beam apparatus of clause 47, wherein the charged particle detector is an electron detector.
67. The charged particle beam apparatus of clause 66, wherein the electron detector is a pixelated electron counting detector.
68. The charged particle beam apparatus of clause 47, wherein the detected charged particle incidence locations are detected secondary electron incidence locations.
69. The charged particle beam apparatus of clause 47, wherein the detected charged particle incidence locations are detected backscattered electron incidence locations.
70. A charged particle beam apparatus, comprising:
   a charged particle beam source configured to generate a beam of primary charged particles;
   an optical system configured to direct the beam of primary charged particles at a sample surface;
   a charged particle detector configured to detect a spatial distribution of detected charged particles returned from the sample surface;
   a controller configured to:
      obtain spatial distribution information of detected charged particle incidence locations on the charged particle detector;
      assign weighting coefficients to the detected charged particle incidence locations based on their respective locations on the detector.
71. The charged particle beam apparatus of clause 70, wherein the controller is further configured to assign the weighting coefficients to the detected charged particle incidence locations based on reference distribution information.
72. The charged particle beam apparatus of clause 70, wherein
   the spatial distribution information of detected charged particle incidence locations comprises a first detected charged particle incidence location and a second detected charged particle incidence location; the first detected charged particle incidence location is closer than the second detected charged particle incidence location to a centroid of the spatial distribution information; and
   a first weighting coefficient assigned to the first detected charged particle incidence location is greater than a second weighting coefficient assigned to the second detected charged particle incidence location.
73. A method, comprising:
   obtaining spatial distribution information of a plurality of detected charged particle incidences on a charged particle detector from a sample pixel on a sample surface;
   generating a spatial counts map of the plurality of detected charged particle incidences from the spatial distribution information;
   reducing a value of a subset of the plurality of detected charged particle incidences in the spatial counts map by assigning weighting coefficients to each of the detected charged particle incidences in the subset, the weighting coefficients being less than one; and
   summing the detected charged particle incidences in the spatial counts map to generate a detection output for the sample pixel.
74. A non-transitory computer-readable medium storing a set of instructions that are executable by at least one processor of a device to cause the device to perform a method comprising:
   obtaining spatial distribution information of a plurality of detected charged particle incidences on a charged particle detector from a sample pixel on a sample surface;
   generating a spatial counts map of the plurality of detected charged particle incidences from the spatial distribution information;
   reducing a value of a subset of the plurality of detected charged particle incidences in the spatial counts map by assigning weighting coefficients to each of the detected charged particle incidences in the subset, the weighting coefficients being less than one; and
   summing the detected charged particle incidences in the spatial counts map to generate a detection output for the sample pixel.
75. A charged particle beam apparatus, comprising:
   a charged particle beam source configured to generate a beam of primary charged particles;
   an optical system configured to direct the beam of primary charged particles at a sample surface;
   a charged particle detector configured to detect a spatial distribution of detected charged particles returned from the sample surface;
   a controller configured to:
      obtain spatial distribution information of a plurality of detected charged particle incidences on a charged particle detector from a sample pixel on a sample surface;
      generate a spatial counts map of the plurality of detected charged particle incidences from the spatial distribution information;
      reduce a value of a subset of the plurality of detected charged particle incidences in the spatial counts map by assigning weighting coefficients to each of the detected charged particle incidences in the subset, the weighting coefficients being less than one; and
      sum the detected charged particle incidences in the spatial counts map to generate a detection output for the sample pixel.
76. A method, comprising:
   obtaining a plurality of detection frames of a charged particle detector from a sample pixel on a sample surface, each of the plurality of detection frames comprising spatial distribution information of zero or more detected charged particle incidence locations on the charged particle detector;
   combining the plurality of detection frames to generate a spatial counts map of the sample pixel; reducing a value of a detected charged particle incidence in the spatial counts map by assigning a weighting coefficient to the detected charged particle incidence, the coefficient being less than one; and
   summing the detected charged particle incidences in the spatial counts map to generate a detection output.
77. A non-transitory computer-readable medium storing a set of instructions that are executable by at least one processor of a device to cause the device to perform a method comprising:
   obtaining a plurality of detection frames of a charged particle detector from a sample pixel on a sample surface, each of the plurality of detection frames comprising spatial distribution information of zero or more detected charged particle incidence locations on the charged particle detector;
   combining the plurality of detection frames to generate a spatial counts map of the sample pixel; reducing a value of a detected charged particle incidence in the spatial counts map by assigning a weighting coefficient to the detected charged particle incidence, the coefficient being less than one; and
   summing the detected charged particle incidences in the spatial counts map to generate a detection output.
78. A charged particle beam apparatus, comprising:
   a charged particle beam source configured to generate a beam of primary charged particles;
   an optical system configured to direct the beam of primary charged particles at a sample surface;
   a charged particle detector configured to detect a spatial distribution of detected charged particles returned from the sample surface;
   a controller configured to:
      obtain a plurality of detection frames of the charged particle detector from a sample pixel on the sample surface, each of the plurality of detection frames comprising spatial distribution information of zero or more detected charged particle incidence locations on the charged particle detector;
      combine the plurality of detection frames to generate a spatial counts map of the sample pixel;
      reduce a value of a detected charged particle incidence in the spatial counts map by assigning a weighting coefficient to the detected charged particle incidence, the coefficient being less than one; and
      sum the detected charged particle incidences in the spatial counts map to generate a detection output.
79. A method comprising:
   obtaining spatial distribution information of detected charged particle incidence locations on a plurality of detection pixels of a charged particle detector in a charged particle beam apparatus;
   storing information of the plurality of detection pixels in a storage device; and
   determining a parameter of the charged particle beam apparatus based on the stored information of the plurality of detection pixels.
80. A non-transitory computer-readable medium storing a set of instructions that are executable by at least one processor of a device to cause the device to perform a method comprising:
   obtaining spatial distribution information of detected charged particle incidence locations on a plurality of detection pixels of a charged particle detector in a charged particle beam apparatus;
   storing information of the plurality of detection pixels in a storage device; and
   determining a parameter of the charged particle beam apparatus based on the stored information of the plurality of detection pixels.
81. A charged particle beam apparatus, comprising:
   a charged particle beam source configured to generate a beam of primary charged particles;
   an optical system configured to direct the beam of primary charged particles at a sample surface;
   a charged particle detector configured to detect a spatial distribution of detected charged particles returned from the sample surface;
   a controller configured to:
      obtain spatial distribution information of detected charged particle incidence locations on a plurality of detection pixels of the charged particle detector;
      store information of the plurality of detection pixels in a storage device; and determine a parameter of the charged particle beam apparatus based on the stored information of the plurality of detection pixels.

Block diagrams in the figures may illustrate the architecture, functionality, and operation of possible implementations of systems, methods, and computer hardware or software products according to various exemplary embodiments of the present disclosure. In this regard, each block in a schematic diagram may represent certain arithmetical or logical operation processing that may be implemented using hardware such as an electronic circuit. Blocks may also represent a module, segment, or portion of code that comprises one or more executable instructions for implementing the specified logical functions. It should be understood that in some alternative implementations, functions indicated in a block may occur out of the order noted in the figures. For example, two blocks shown in succession may be executed or implemented substantially concurrently, or two blocks may sometimes be executed in reverse order, depending upon the functionality involved. Some blocks may also be omitted. It should also be understood that each block of the block diagrams, and combination of the blocks, may be implemented by special purpose hardware-based systems that perform the specified functions or acts, or by combinations of special purpose hardware and computer instructions.

It will be appreciated that the embodiments of the present disclosure are not limited to the exact construction that has been described above and illustrated in the accompanying drawings, and that various modifications and changes can be made without departing from the scope thereof. For example, a charged particle inspection system may be but one example of a charged particle beam system consistent with embodiments of the present disclosure.

## Claims

1. A non-transitory computer-readable medium storing a set of instructions that are executable by at least one processor of a device to cause the device to perform a method comprising:
obtaining spatial distribution information of detected charged particle incidence locations on a charged particle detector;
comparing the spatial distribution information to reference distribution information; and
assigning a value to a detected charged particle incidence location based on the comparison.

2. The non-transitory computer-readable medium of claim 1, wherein the reference distribution information comprises expected incidence locations on the charged particle detector.

3. The non-transitory computer-readable medium of claim 2, wherein the expected incidence locations are based on a charged particle beam parameter of a charged particle beam apparatus.

4. The non-transitory computer-readable medium of claim 3, wherein the charged particle beam parameter comprises a primary beam parameter, a detector location, an electrode voltage, a charged particle landing energy, or a location of a sample pixel within a field of view of an charged particle beam apparatus.

5. The non-transitory computer-readable medium of claim 2, wherein the expected incidence locations are based on a sample pixel parameter of a sample at a sample pixel location in a charged particle beam process.

6. The non-transitory computer-readable medium of claim 5, wherein the sample pixel parameter comprises a material characteristic or topography of the sample at the sample pixel location.

7. The non-transitory computer-readable medium of claim 1, wherein:
the spatial distribution information comprises a first spatial counts map of a first sample pixel in a charged particle beam process; and
the reference distribution information comprises a second spatial counts map of a second sample pixel in the charged particle beam process.

8. The non-transitory computer-readable medium of claim 7, wherein the first sample pixel is adjacent to the second sample pixel.

9. The non-transitory computer-readable medium of claim 7, wherein the reference distribution information further comprises a third spatial counts map of a third sample pixel in the charged particle beam process.

10. The non-transitory computer-readable medium of claim 1, wherein:
the spatial distribution information comprises a first frame of a spatial counts map of a sample pixel in a charged particle beam process; and
the reference distribution information comprises a second frame of the spatial counts map of the sample pixel in the charged particle beam process.

11. The non-transitory computer-readable medium of claim 1, wherein the set of instructions that are executable by the at least one processor of the device cause the device to further perform:
assigning a plurality of values to a plurality of detected charged particle incidence locations based on the comparison, wherein the plurality of values comprises a plurality of weighting coefficients in a weighting coefficient distribution.

12. The non-transitory computer-readable medium of claim 11, wherein the weighting coefficient distribution has a continuous profile, a binary profile, or a stepped profile.

13. The non-transitory computer-readable medium of claim 11, wherein the plurality of weighting coefficients corresponds to a plurality of determined probabilities that the plurality of detected charged particle incidence locations represent real charged particle landing events.

14. The non-transitory computer-readable medium of claim 11, wherein:
the spatial distribution information of detected charged particle incidence locations comprises a first detected charged particle incidence location and a second detected charged particle incidence location;
the first detected charged particle incidence location is closer than the second detected charged particle incidence location to a centroid of the spatial distribution information; and
a first weighting coefficient assigned to the first detected charged particle incidence location is greater than a second weighting coefficient assigned to the second detected charged particle incidence location.

15. The non-transitory computer-readable medium of claim 11, wherein the set of instructions that are executable by the at least one processor of the device cause the device to further perform:
after assigning the plurality of weighting coefficients to the plurality of detected charged particle incidence locations to achieve a plurality of weighted detected charged article incidence locations, summing the plurality of weighted detected charged particle incidence locations; and
generating a detector output based on the summed plurality of weighted detected charged particle incidence locations.
